# EUROPEAN PATENT APPLICATION

(11) **EP 4 646 060 A1**
(43) Date of publication of application: **05.11.2025**
(21) Application number: 25743689.9
(22) Date of filing: 26.01.2025
(51) Int. Cl.: H10F 10/166, H10F 19/00, H10F 10/16

(54) **SOLAR CELL AND MANUFACTURING METHOD THEREFOR, AND PHOTOVOLTAIC MODULE**

(30) Priority: 04.02.2024 CN 202410160240; 17.01.2025 CN 202510082596; 17.01.2025 CN 202510081229; 17.01.2025 CN 202510080848; 17.01.2025 CN 202510081825
(71) Applicant: Longi Green Energy Technology Co., Ltd., Xi'an, Shaanxi 710100 (CN)
(72) Inventor: BIAN, Chunlong, Shaanxi 710100 (CN); TONG, Hongbo, Shaanxi 710100 (CN); ZHANG, Hongchao, Shaanxi 710100 (CN); WANG, Yawen, Shaanxi 710100 (CN); HUANG, Min, Shaanxi 710100 (CN)
(74) Representative: Pfenning, Meinig & Partner mbB
(86) International application number: PCT/CN2025/075104
(87) International publication number: WO 2025/162357

(57) **Abstract**

The present disclosure discloses a solar cell, a manufacturing method thereof, and a photovoltaic module. The solar cell includes a semiconductor substrate, the semiconductor substrate having a first surface and a second surface opposite to each other; a doped semiconductor layer, disposed on the first surface of the semiconductor substrate; a dielectric layer, disposed on a side of the doped semiconductor layer facing away from the semiconductor substrate; the dielectric layer comprising a plurality of openings, the opening exposing a partial region of the doped semiconductor layer; and a plurality of holes being formed on a side of a part of the doped semiconductor layer exposed at the opening and facing away from the semiconductor substrate; and an electrode, disposed on a side of the dielectric layer away from the semiconductor substrate, the electrode being electrically connected to the doped semiconductor layer through the opening on the dielectric layer. The present disclosure reduces a risk that the electrode is separated from the doped semiconductor layer, and improves structural reliability of the solar cell.

## Description

### CROSS-REFERENCE TO RELATED APPLICATIONS

This application claims priority to Chinese Patent Application No. 202410160240.1, filed on February 4, 2024, Chinese Patent Application No. 202510082596.2, filed on January 17, 2025, Chinese Patent Application No. 202510081229.0, filed on January 17, 2025, Chinese Patent Application No. 202510080848.8, filed on January 17, 2025, and Chinese Patent Application No. 202510081825.9, filed on January 17, 2025, which are incorporated herein by reference in their entireties.

### TECHNICAL FIELD

The present disclosure relates to the field of solar cell technologies, and in particular, to a solar cell, a manufacturing method thereof, and a photovoltaic module.

### BACKGROUND

At present, solar cells are increasingly widely used as a new energy alternative solution. A photovoltaic solar cell is an apparatus that converts sunlight energy into electric energy. Specifically, the solar cell generates carriers by using the photovoltaic principle, and leads the carriers out by using electrodes, thereby facilitating effective use of the electric energy.

In a conventional high-temperature metallization process, high-temperature silver pastes go through high-temperature sintering on a dielectric layer such as silicon nitride, and the pastes may penetrate the silicon nitride interface to form good metal contact with a lower-layer doped semiconductor layer. Because costs of high-temperature silver pastes are high, the industry has been actively researching for other metallization processes in recent years.

### SUMMARY

The present disclosure aims to provide a solar cell, a manufacturing method thereof, and a photovoltaic module, to reduce costs of a metallization process, increase a binding force between an electrode and a doped semiconductor layer on a semiconductor substrate, reduce a risk that the electrode is separated from the doped semiconductor layer, and improve structural stability of the solar cell.

According to a first aspect of the present disclosure, a solar cell is provided, including: a semiconductor substrate, the semiconductor substrate having a first surface and a second surface opposite to each other; a doped semiconductor layer, disposed on the first surface of the semiconductor substrate; a dielectric layer, disposed on a side of the doped semiconductor layer facing away from the semiconductor substrate; the dielectric layer comprising a plurality of openings, the opening exposing a partial region of the doped semiconductor layer; and a plurality of holes being formed on a side of a part of the doped semiconductor layer exposed at the opening and facing away from the semiconductor substrate; and an electrode, disposed on a side of the dielectric layer away from the semiconductor substrate, the electrode being electrically connected to the doped semiconductor layer through the opening on the dielectric layer.

According to a second aspect, a photovoltaic module is provided, including a plurality of solar cell strings, the solar cell string including a plurality of solar cells and a plurality of interconnection members, and the interconnection members being configured to connect the plurality of solar cells in series; where the solar cell is any one of the solar cell according to the present disclosure.

According to a third aspect, a manufacturing method of a solar cell is provided, including: providing a semiconductor substrate, the semiconductor substrate having a first surface and a second surface opposite to each other; forming a doped semiconductor layer on the first surface and/or the second surface; forming a dielectric layer on a side of the doped semiconductor layer facing away from the semiconductor substrate; forming a penetrating opening on the dielectric layer, so that at least a part of the doped semiconductor layer is exposed from the opening, and forming a plurality of holes on a side of a part of the doped semiconductor layer exposed at the opening and facing away from the semiconductor substrate; and forming an electrode at the opening, and making the electrode to be electrically connected to the doped semiconductor layer.

### BRIEF DESCRIPTION OF THE DRAWINGS

The accompanying drawings described herein are used to provide a further understanding of the present disclosure, and form a part of the present disclosure. Exemplary embodiments of the present disclosure and descriptions thereof are used to explain the present disclosure, and do not constitute any inappropriate limitation to the present disclosure. In the accompanying drawings:
FIG. 1 is a schematic cross-sectional view of a first structure of a solar cell according to an embodiment of the present disclosure;
FIG. 2 is a schematic cross-sectional view of a second structure of a solar cell according to an embodiment of the present disclosure;
FIG. 3 is a schematic diagram of a solar cell after laser mold opening according to an embodiment of the present disclosure;
FIG. 4 is a schematic cross-sectional view of a first structure of a back contact solar cell according to an embodiment of the present disclosure;
FIG. 5 is a schematic cross-sectional view of a second structure of a back contact solar cell according to an embodiment of the present disclosure;
FIG. 6 is a schematic cross-sectional view of a third structure of a back contact solar cell according to an embodiment of the present disclosure;
FIG. 7 is a schematic cross-sectional view of a fourth structure of a back contact solar cell according to an embodiment of the present disclosure;
FIG. 8-1 is an SEM image of a solar cell at a surface of an opening according to an embodiment of the present disclosure;
FIG. 8-2 is a topography top view under a scanning electron microscope of a solar cell at an opening according to an embodiment of the present disclosure;
FIG. 8-3 is a topography top view under a scanning electron microscope of an N-type doped semiconductor layer of a solar cell at an opening according to an embodiment of the present disclosure;
FIG. 8-4 is a topography top view under a scanning electron microscope of a P-type doped semiconductor layer of a solar cell at an opening according to an embodiment of the present disclosure;
FIG. 8-5 is a topography diagram under a scanning electron microscope of an N-type doped semiconductor layer of a solar cell at an opening according to an embodiment of the present disclosure;
FIG. 8-6 is a topography diagram under a scanning electron microscope of a P-type doped semiconductor layer of a solar cell at an opening according to an embodiment of the present disclosure;
FIG. 8-7 is a topography diagram under a scanning electron microscope of another N-type doped semiconductor layer of a solar cell at an opening according to an embodiment of the present disclosure;
FIG. 8-8 is a topography diagram under a scanning electron microscope of another P-type doped semiconductor layer of a solar cell at an opening according to an embodiment of the present disclosure;

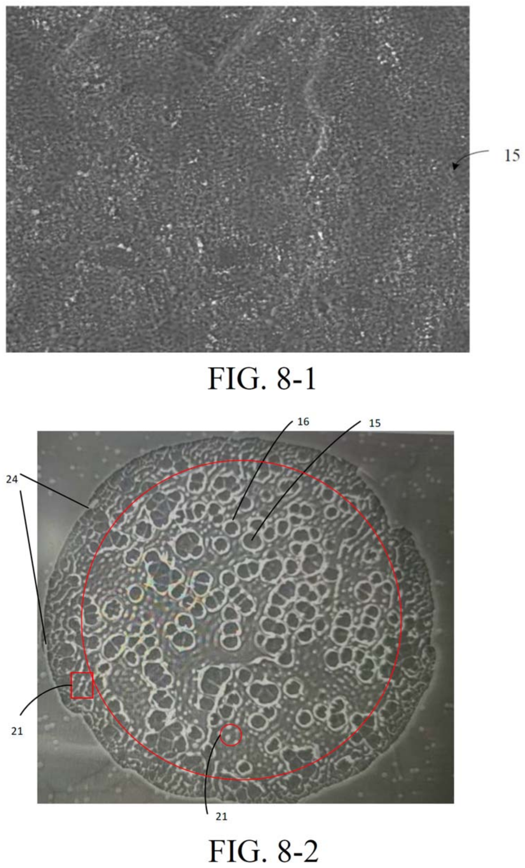

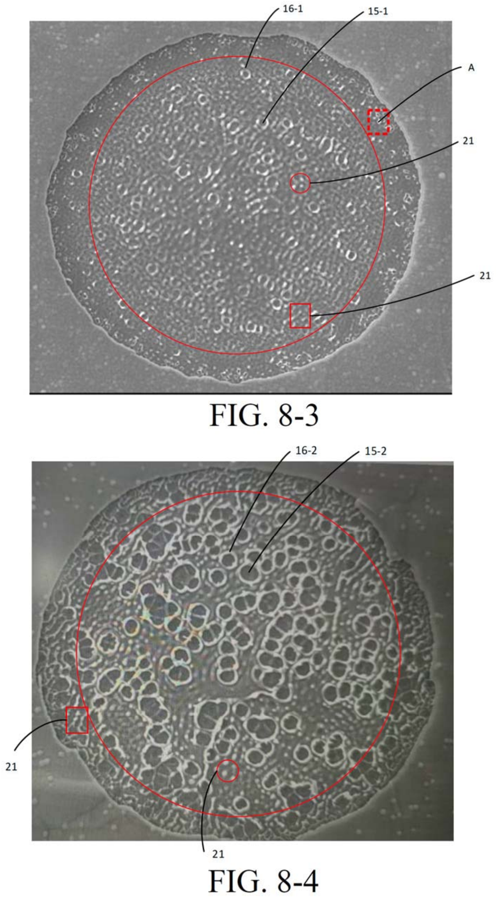

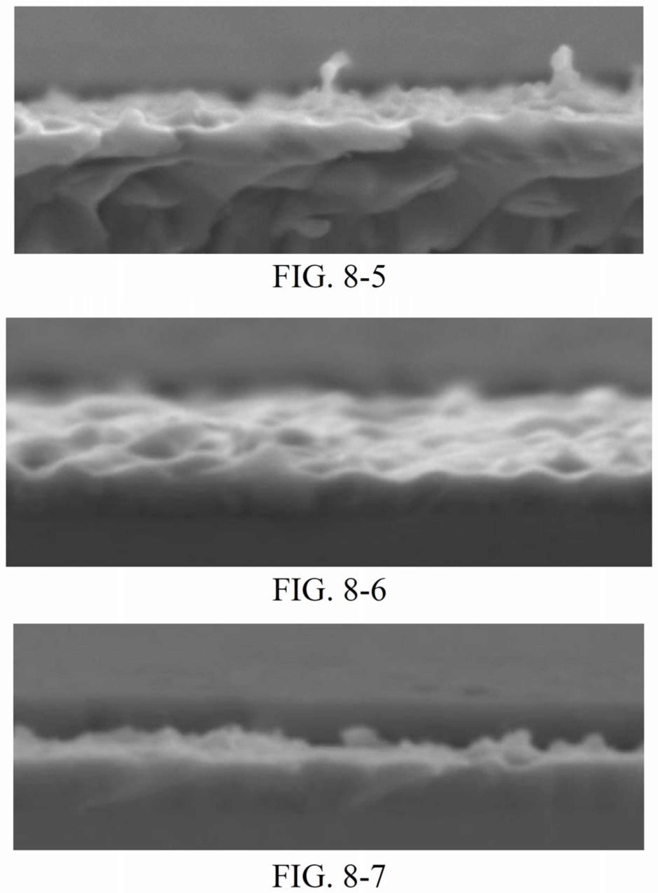

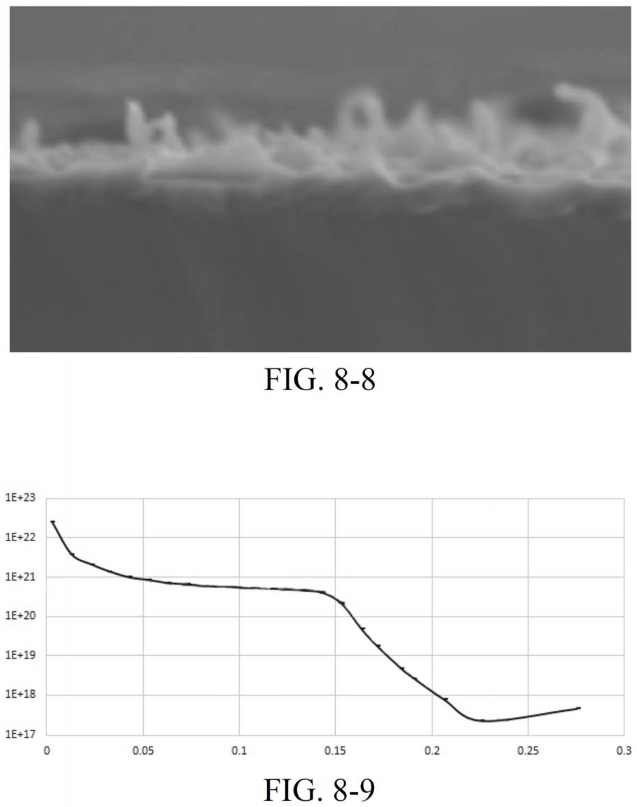

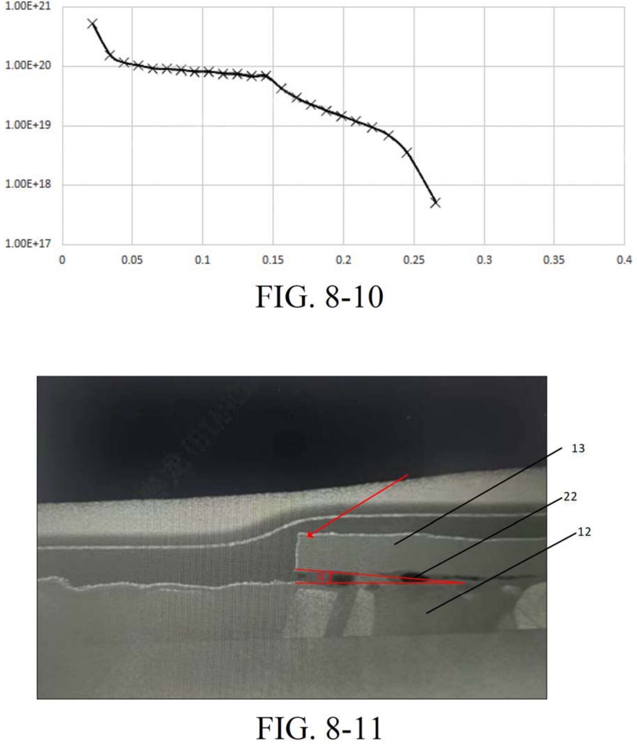

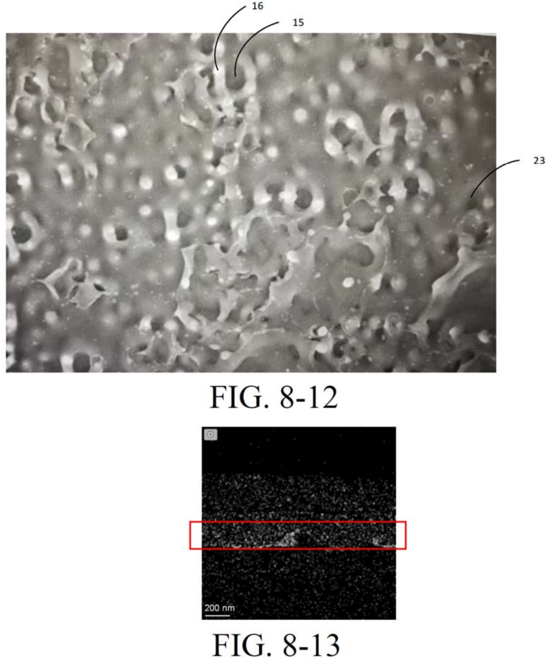

FIG. 8-9 is an ECV test diagram of doping concentration distribution of an N-type doped semiconductor layer along a thickness direction according to an embodiment of the present disclosure;
FIG. 8-10 is an ECV test diagram of doping concentration distribution of a P-type doped semiconductor layer along a thickness direction according to an embodiment of the present disclosure;
FIG. 8-11 is a structural cross-sectional view of a solar cell according to an embodiment of the present disclosure;
FIG. 8-12 is a partial enlarged view at an edge region A of the opening shown in FIG. 8-3;
FIG. 8-13 is a scanning diagram of surface oxygen of a solar cell after laser mold opening according to an embodiment of the present disclosure;

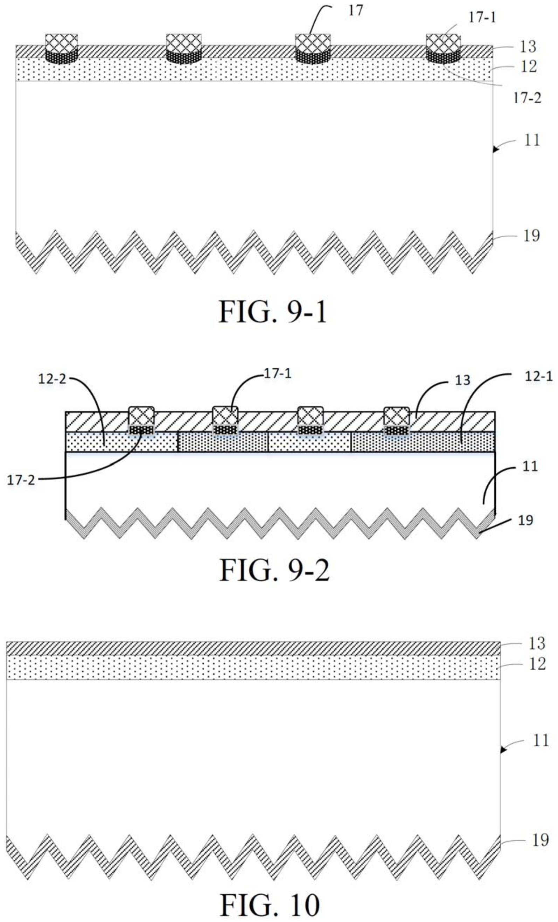

FIG. 9-1 is a schematic cross-sectional view of a third structure of a solar cell according to an embodiment of the present disclosure;
FIG. 9-2 is a schematic cross-sectional view of a fifth structure of a back contact solar cell according to an embodiment of the present disclosure;
FIG. 10 is a first schematic structural diagram of a solar cell in a manufacturing process according to an embodiment of the present disclosure;

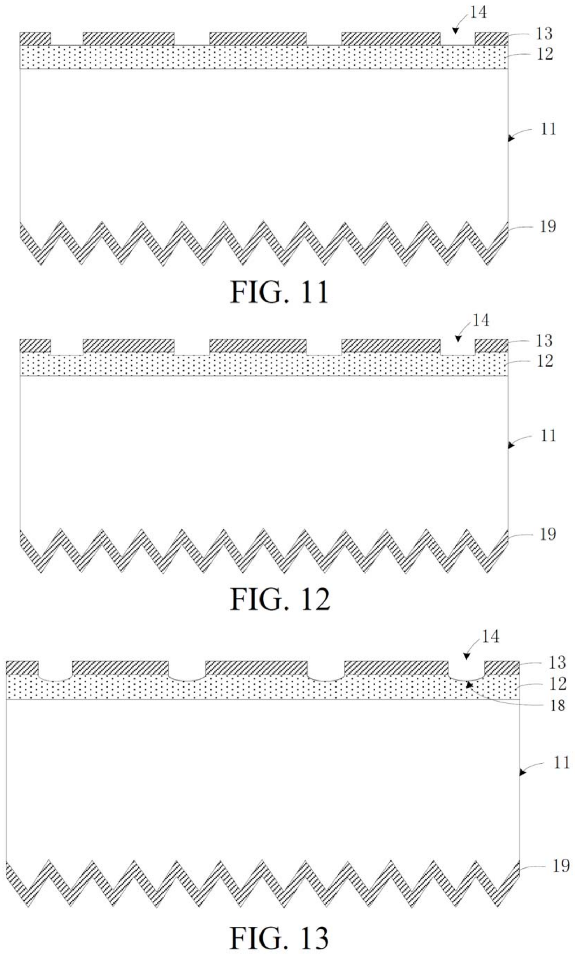

FIG. 11 is a second schematic structural diagram of a solar cell in a manufacturing process according to an embodiment of the present disclosure;
FIG. 12 is a third schematic structural diagram of a solar cell in a manufacturing process according to an embodiment of the present disclosure;
FIG. 13 is a fourth schematic structural diagram of a solar cell in a manufacturing process according to an embodiment of the present disclosure; and

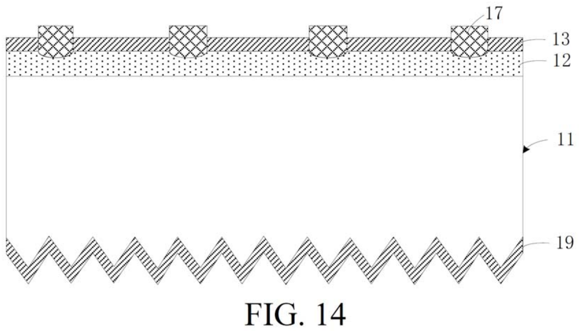

FIG. 14 is a fifth schematic structural diagram of a solar cell in a manufacturing process according to an embodiment of the present disclosure.

Reference numerals: 11: Semiconductor substrate, 12: doped semiconductor layer, 12-1: first doped semiconductor layer, 12-2: second doped semiconductor layer, 13: dielectric layer, 14: opening, 14-1: first opening, 14-2: second opening, 15: hole, 15-1: first hole, 15-2: second hole, 16: annular protrusion part, 16-1: annular protrusion part of the first hole, 16-2: annular protrusion part of the second hole, 17: electrode, 17A: first electrode, 17B: second electrode, 17-1: connection electrode, 17-2: conductive contact layer, 18: groove, 19: second passivation layer, 20: first passivation layer, 21: discontinuous protrusion part, 22: aperture, 23: concavity, and 24: crack.

### DETAILED DESCRIPTION

Embodiments of the present disclosure are described below with reference to the accompanying drawings. However, it should be understood that, the descriptions are merely exemplary, and is not intended to limit the scope of the present disclosure. In addition, in the following descriptions, descriptions of well-known structures and technologies are omitted, to avoid unnecessarily obscuring the concept of the present disclosure.

The accompanying drawings show various schematic structural diagrams according to the embodiments of the present disclosure. The accompanying drawings are not drawn to scale, some details are enlarged for the purpose of clarity, and some details may be omitted. Shapes of various regions and layers shown in the drawings, and relative sizes and positional relationships between the various regions and layers are merely exemplary, and may deviate in practice due to manufacturing tolerances or technical limitations, and a person skilled in the art may additionally design regions/layers with different shapes, sizes, and relative positions according to actual requirements.

In the context of the present disclosure, when a layer/element is referred to as being "on" another layer/element, the layer/element may be directly on the another layer/element, or an intermediate layer/element may exist between the layer/element and the another layer/element. In addition, if one layer/element is "above" another layer/element in an orientation, when the orientation is turned, the layer/element may be "below" the another layer/element. To make the technical problems to be resolved by, the technical solutions, and the beneficial effects of the present disclosure clearer and more comprehensible, the following further describes the present disclosure in detail with reference to the accompanying drawings and embodiments. It should be understood that, the specific embodiments described herein are merely used for describing the present disclosure and are not used for limiting the present disclosure.

In addition, the terms "first" and "second" are used merely for the purpose of description, and shall not be construed as indicating or implying relative importance or implying a quantity of indicated technical features. Therefore, a feature defined by "first" or "second" may explicitly or implicitly include one or more features. In the descriptions of the present disclosure, "a plurality of" means two or more, unless otherwise definitely and specifically limited. "Several" means one or more, unless otherwise definitely and specifically limited.

In the descriptions of the present disclosure, it should be noted that, unless otherwise explicitly stipulated and restricted, terms "installation", "joint connection", and "connection" should be understood broadly, which, for example, may be a fixed connection, or may be a detachable connection, or an integral connection; or may be a mechanical connection, or may be an electrical connection; or may be a direct connection, or may be an indirect connection by using a medium, or may be an internal communication between two components, or may be an interactive relationship between two components. A person of ordinary skill in the art may understand the specific meanings of the foregoing terms in the present disclosure according to specific situations.

An existing solar cell usually includes a semiconductor substrate, a doped semiconductor layer, a dielectric layer, and an electrode. The doped semiconductor layer is formed on a light-facing surface and/or a back surface of the semiconductor substrate. The dielectric layer is formed on a side of the doped semiconductor layer facing away from the semiconductor substrate as a surface passivation layer and/or an anti-reflection layer. The surface passivation layer is configured to passivate a surface defect on the side of the doped semiconductor layer facing away from the semiconductor substrate, to reduce carrier recombination efficiency of the doped semiconductor layer. The anti-reflection layer is configured to reduce reflection of incident light, to improve a light absorption rate of the semiconductor substrate. The electrode at least partially penetrates the dielectric layer and is in electrical contact with the doped semiconductor layer, to export carriers collected by the doped semiconductor layer, and form a photocurrent.

In an actual application process, the electrode may be formed by using a process such as screen printing, plating, or physical vapor deposition. Currently, the electrode is formed by using the screen printing process, and high-temperature silver pastes are used as the material for manufacturing the electrode. However, costs of the high-temperature silver pastes are very high. Consequently, in manufacturing costs of the entire solar cell, except costs of the semiconductor substrate, manufacturing costs of the electrode are very high. Therefore, how to reduce the manufacturing costs of the electrode has also become a problem that currently needs to be resolved urgently in the industry.

For this problem, in the industry, a mold is opened at a dielectric layer such as a silicon nitride interface, to remove a part of the dielectric layer and form a bare contact window of a doped semiconductor layer, and an electrode is manufactured by using a low-temperature metallization process, for example, high-temperature silver pastes are replaced by using low-temperature pastes, or an electrode is formed by using a plating process. However, currently, compared with a binding force provided by a composite crystal formed by burning and fusing a glass body inside silver pastes and a silicon interface in an electrode manufactured by using the high-temperature silver pastes, a binding force between the electrode formed through low-temperature metallization and the doped semiconductor layer is low, causing a high risk that the electrode is separated from the doped semiconductor layer, and reducing structural reliability of the solar cell.

To resolve the foregoing technical problem, embodiments of the present disclosure provide a solar cell. In terms of a battery type, the solar cell provided in the embodiments of the present disclosure includes, but is not limited to, any one of the following photovoltaic solar cells that can convert light energy into electric energy. For example, the solar cell provided in the embodiments of the present disclosure may be any one of a tunnel oxide passivated contact solar cell (TOPcon), a TOPcon back contact solar cell (TBC), a hybrid passivated back contact solar cell (HPBC), and a bifacial hybrid cell.

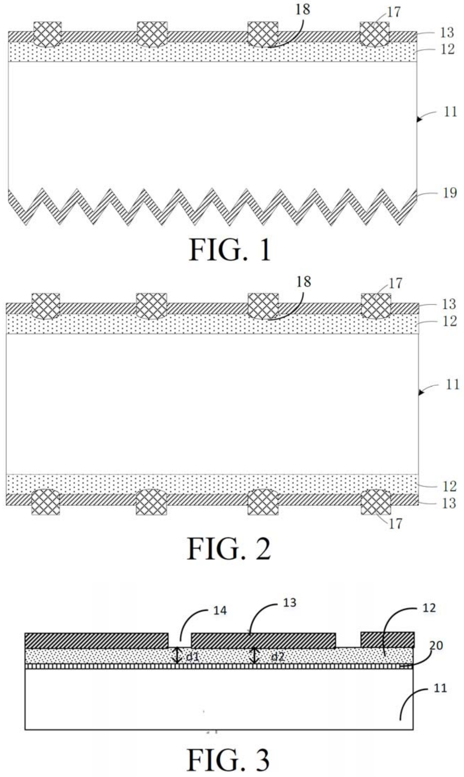

In terms of a forming position of an electrode, the solar cell provided in the embodiments of the present disclosure may be a back contact solar cell. As shown in FIG. 1, in this case, a positive electrode and a negative electrode of the solar cell are both formed on a back surface side of a semiconductor substrate. Alternatively, a solar cell provided in an embodiment of the present disclosure may be a bifacial contact cell. As shown in FIG. 2, in this case, a positive electrode and a negative electrode of the solar cell are respectively formed on a light-facing surface side and a back surface side of a semiconductor substrate.

Referring to FIG. 1 to FIG. 3, a solar cell provided in an embodiment of the present disclosure includes: a semiconductor substrate 11, a doped semiconductor layer 12, a dielectric layer 13, and an electrode 17.

Herein, the semiconductor substrate 11 has a first surface and a second surface opposite to each other. The first surface of the semiconductor substrate 11 may correspond to a back surface of the solar cell. In this case, the second surface of the semiconductor substrate 11 corresponds to a light-facing surface of the solar cell. Surface topography of the first surface and the second surface of the semiconductor substrate 11 are not limited in the embodiments of the present disclosure. For example, as shown in FIG. 2, the first surface and the second surface of the semiconductor substrate 11 are both planar. For another example, as shown in FIG. 1, the second surface of the semiconductor substrate 11 may alternatively be suede, and the first surface of the semiconductor substrate 11 is at least partially planar. For another example, the first surface and the second surface of the semiconductor substrate 11 are both textured.

In an embodiment, the semiconductor substrate 11 may be a silicon substrate. A conductivity type of the semiconductor substrate 11 may be an N-type or a P-type. Alternatively, the semiconductor substrate 11 is of a near-intrinsic conductivity type, and a crystal type of the semiconductor substrate may be monocrystalline, polycrystalline, or the like.

The doped semiconductor layer 12 may be disposed on the first surface of the semiconductor substrate 11. It may be understood that, the doped semiconductor layer 12 may alternatively be disposed on the second surface of the semiconductor substrate 11, or doped semiconductor layers may be disposed on both the first surface and the second surface of the semiconductor substrate 11, as shown in FIG. 2. The doped semiconductor layer 12 in the present disclosure may also be referred to as a conductive doped layer.

A forming position of the doped semiconductor layer 12 on the semiconductor substrate 11 may be determined based on the type of the solar cell. It should be noted that, the doped semiconductor layer 12 in this embodiment of the present disclosure refers to a doped semiconductor layer at which a hole is formed at an opening of a dielectric layer on a side facing away from the semiconductor substrate, and may also be referred to as a first doped semiconductor layer. In some examples, the doped semiconductor layer 12 in this embodiment of the present disclosure refers to a semiconductor layer at which a hole is formed at an opening of a dielectric layer on a side facing away from the semiconductor substrate, and an annular protrusion part is formed at an edge of the hole. Different from the doped semiconductor layer (that is, the first doped semiconductor layer), a third doped semiconductor layer described below refers to a semiconductor layer at which no hole is formed.

For example, when the solar cell provided in this embodiment of the present disclosure is a bifacial contact solar cell, the doped semiconductor layer 12 may be formed only on one side of the first surface or the second surface of the semiconductor substrate 11. In this case, a conductivity type of the doped semiconductor layer 12 may be opposite to the conductivity type of the semiconductor substrate 11. In this case, the solar cell further includes a third doped semiconductor layer formed on a side of the semiconductor substrate 11 facing away from the doped semiconductor layer 12 and whose conductivity type is the same as that of the semiconductor substrate. Alternatively, when the doped semiconductor layer is formed only on one side of the first surface or the second surface of the semiconductor substrate 11, a conductivity type of the doped semiconductor layer may be the same as the conductivity type of the semiconductor substrate 11, and in addition, the solar cell further includes a third doped semiconductor layer formed on a side of the semiconductor substrate facing away from the doped semiconductor layer, where a conductivity type of the third doped semiconductor layer is opposite to the conductivity type of the semiconductor substrate. It is clear that, when the solar cell provided in this embodiment of the present disclosure is a bifacial contact cell, the solar cell may alternatively not include the foregoing third doped semiconductor layer.

Alternatively, doped semiconductor layers 12 may be formed on two sides of the first surface and the second surface of the semiconductor substrate 11. In this case, the two doped semiconductor layers 12 respectively located on the first surface and the second surface of the semiconductor substrate 11 have opposite conductivity types.

When the solar cell provided in this embodiment of the present disclosure is a bifacial contact cell, the doped semiconductor layer 12 may be disposed on the entire of the first surface and/or the second surface of the semiconductor substrate 11, or may be disposed on a partial region of the first surface and/or the second surface of the semiconductor substrate 11.

For another example, when the solar cell provided in this embodiment of the present disclosure is a back contact cell, the doped semiconductor layer 12 is formed on a side of the first surface of the semiconductor substrate 11. A conductivity type of the doped semiconductor layer 12 may be the same as the conductivity type of the semiconductor substrate 11, and in this case, the solar cell further includes a third doped semiconductor layer formed on the first surface of the semiconductor substrate 11 and distributed alternately with the doped semiconductor layer 12, where a conductivity type of the third doped semiconductor layer is opposite to the conductivity type of the semiconductor substrate 11. Alternatively, a conductivity type of the doped semiconductor layer 12 may be opposite to the conductivity type of the semiconductor substrate 11, and in this case, the solar cell may include a third doped semiconductor layer formed on the first surface of the semiconductor substrate 11 and distributed alternately with the doped semiconductor layer 12, where a conductivity type of the third doped semiconductor layer is the same as the conductivity type of the semiconductor substrate 11. It is clear that, when the solar cell provided in this embodiment of the present disclosure is a back contact cell, the solar cell may alternatively not include the foregoing third doped semiconductor layer; alternatively, doped semiconductor layers 12 located on different regions on the side of the first surface of the semiconductor substrate 11 have opposite conductivity types, and different doped semiconductor layers 12 with opposite conductivity types are distributed alternately.

When the solar cell further includes the third doped semiconductor layer, a conductivity type of the third doped semiconductor layer may be determined according to an actual requirement, provided that the conductivity type of the doped semiconductor layer 12 is opposite to the conductivity type of the third doped semiconductor layer. For example, materials of the doped semiconductor layer 12 and the third doped semiconductor layer may be semiconductor materials such as silicon, germanium, silicon carbide, or gallium arsenide. In terms of an internal arrangement form of matter, the doped semiconductor layer 12 and the third doped semiconductor layer may be amorphous, microcrystalline, monocrystalline, nanocrystalline, polycrystalline, or the like. Materials of the doped semiconductor layer 12 and the third doped semiconductor layer may be the same or may be different.

The dielectric layer 13 is disposed on a side of the doped semiconductor layer 12 facing away from the semiconductor substrate 11. A plurality of penetrating openings 14 are disposed in the dielectric layer 13, and the opening 14 may also be referred to as a conductive window in this embodiment of the present disclosure. The opening 14 exposes at least a partial region of the doped semiconductor layer 12. A plurality of holes 15 are formed on a side of a part of the doped semiconductor layer 12 exposed at the opening 14 and facing away from the semiconductor substrate 11.

It should be noted that, in this embodiment of the present disclosure, the hole does not penetrate the doped semiconductor layer, and is a blind hole.

The dielectric layer 13 may passivate a surface of the doped semiconductor layer 12, to reduce a carrier recombination rate. Because the dielectric layer 13 is a non-conductive insulation layer, a penetrating opening 14 is disposed at the dielectric layer 13. The opening 14 in this embodiment of the present disclosure may be of a shape such as a circle, a square, or an ellipse. The opening 14 exposes at least a partial region of the doped semiconductor layer 12. In addition, a plurality of holes 15 are formed on a side of a part of the doped semiconductor layer 12 exposed at the opening 14 and facing away from the semiconductor substrate 11. By using this manner, the electrode can be formed at the opening 14 by using a low-temperature metallization process, and costs of the metallization process can be reduced. Moreover, because the plurality of holes 15 are formed on the side of the part of the doped semiconductor layer 12 exposed at the opening 14 and facing away from the semiconductor substrate 11, the side of the part of the doped semiconductor layer 12 exposed at the opening 14 and facing away from the semiconductor substrate 11 has a bumpy surface feature, and this facilitates increasing a surface roughness and a specific surface area of the doped semiconductor layer 12 at the opening. Based on this, compared with a case in an existing solar cell in which an electrode 17 is formed on a flat surface of a doped semiconductor layer, when the electrode 17 is formed on a bumpy surface of the doped semiconductor layer 12 in the solar cell provided in this embodiment of the present disclosure, a contact area between the part of the doped semiconductor layer 12 exposed at the opening 14 and the electrode 17 is larger, and this helps to increase a binding force between the electrode 17 and the doped semiconductor layer 12, enhance a connection strength between the two, reduce a risk that the electrode 17 is separated from the doped semiconductor layer 12, and improve structural reliability of the solar cell. In addition, because the contact area is larger, a contact resistance between the electrode 17 and the doped semiconductor layer 12 can also be lowered, thereby improving contact performance, and further improving photoelectric conversion efficiency of the solar cell.

The dielectric layer 13 may be of a single-layer structure, or may be of a multi-layer structure. In some examples, the dielectric layer 13 may include a surface passivation layer, or may include another possible layer such as an anti-reflection layer, or may include a surface passivation layer and an anti-reflection layer that are disposed in a stacked manner. A structure of the dielectric layer 13 is not specifically limited in this embodiment of the present disclosure, and the structure of the dielectric layer may be set according to a requirement of the solar cell. For example, for a TBC solar cell, a dielectric layer 13 on a back surface of the TBC battery may include a surface passivation layer and an anti-reflective layer that are disposed in a stacked manner. For a Topcon solar cell, a dielectric layer 13 on a back surface of the Topcon cell may include an anti-reflection layer, or may include a surface passivation layer, or may include a surface passivation layer and an anti-reflection layer that are disposed in a stacked manner. Dielectric layers of light-facing surfaces of the TBC cell and the Topcon cell may each include a surface passivation layer and an anti-reflection layer that are disposed in a stacked manner.

A material of the dielectric layer 13 is an insulating material. In some examples, when the dielectric layer includes the surface passivation layer, the material of the dielectric layer 13 may include at least one of silicon nitride, silicon oxynitride, silicon carbide, and aluminum oxide. In some examples, when the dielectric layer includes the surface passivation layer and the anti-reflection layer that are disposed in a stacked manner, a material of the surface passivation layer may include one or more of aluminum oxide, silicon oxide, and intrinsic amorphous silicon, and a material of the anti-reflection layer may include one or more of silicon nitride, silicon oxide, and silicon oxynitride. In some examples, the material of the dielectric layer 13 includes silicon nitride. In this case, because the silicon nitride has a high electrical resistance, when the material of the dielectric layer 13 includes silicon nitride, it is beneficial to improving insulation performance of the dielectric layer 13, and has a good passivation effect. Therefore, the dielectric layer 13 whose material includes silicon nitride passivates the surface of the doped semiconductor layer 12, and this is beneficial to reducing a carrier recombination rate. In addition, because silicon nitride further has good anti-reflection effects, the photoelectric conversion efficiency of the solar cell can be improved.

In some embodiments, the solar cell may further include a first passivation layer 20 located between the semiconductor substrate 11 and the doped semiconductor layer 12. The first passivation layer 20 may passivate at least a surface of the semiconductor substrate 11 corresponding to the doped semiconductor layer 12, and reduce a carrier recombination rate on the surface of the semiconductor substrate 11. In addition, the doped semiconductor layer 12 formed on the first passivation layer 20 can selectively collect carriers of a corresponding conductivity type in the semiconductor substrate 11, to further improve the photoelectric conversion efficiency of the solar cell provided in this embodiment of the present disclosure.

The first passivation layer 20 may be one or more layers, or may be formed by different materials in different regions. A material of the first passivation layer 20 may be determined based on a material of the doped semiconductor layer 12. For example, when the material of the doped semiconductor layer 12 includes one or more of doped amorphous silicon, doped microcrystalline silicon, or doped nanocrystalline silicon, the first passivation layer 20 may be an intrinsic amorphous silicon layer, an intrinsic microcrystalline silicon layer, an intrinsic nanocrystalline silicon layer, or a mixed layer of at least two of the foregoing three layers. In this case, the doped semiconductor layer 12 and the first passivation layer 20 may form a heterogeneous contact structure.

For another example, when the doped semiconductor layer 12 is a doped polycrystalline silicon layer, the first passivation layer 20 may be a tunneling passivation layer. In this case, the doped semiconductor layer 12 and the first passivation layer 20 may form a tunneling passivation contact structure. In addition, a material of the tunneling passivation layer may include any dielectric material having a tunneling passivation function. For example, the material of the tunneling passivation layer may include one or more of silicon oxide, aluminum oxide, titanium oxide, hafnium oxide, gallium oxide, titanium pentoxide, niobium pentoxide, silicon nitride, silicon carbonitride, aluminum nitride, titanium nitride, or titanium carbonitride.

In some implementations, the doped semiconductor layer 12 is formed only on one side of the first surface or the second surface of the semiconductor substrate 11, and the solar cell may further include a second passivation layer 19 formed on a side of the semiconductor substrate 11 facing away from the doped semiconductor layer 12. The second passivation layer 19 can passivate the side of the semiconductor substrate 11 facing away from the doped semiconductor layer 12, to reduce a carrier recombination rate on the surface of the semiconductor substrate 11, and further improve the photoelectric conversion efficiency of the solar cell. Specifically, a material and a thickness of the second passivation layer 19 are not specifically limited in this embodiment of the present disclosure. For the material and the thickness of the second passivation layer 19, refer to the material of the dielectric layer. For example, a material of the second passivation layer 19 may include any one or more insulating materials such as silicon oxide, aluminum oxide, and silicon nitride.

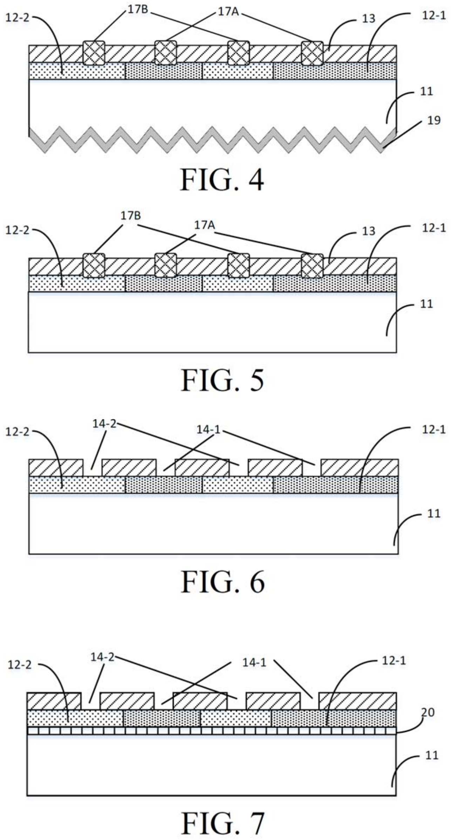

Referring to FIG. 4 to FIG. 7, in some embodiments of the present disclosure, the solar cell is a back contact solar cell. The solar cell provided in this embodiment includes: a semiconductor substrate 11, a first doped semiconductor layer 12-1, a second doped semiconductor layer 12-2, a dielectric layer 13, a first electrode 17A, and a second electrode 17B. It should be noted that, FIG. 4 and FIG. 5 are merely used for exemplarily describing a structure of the solar cell, and a thickness and surface topography of each layer are not limited. FIG. 6 and FIG. 7 are merely used for exemplarily describing a structure of the solar cell and disposing of an opening of the dielectric layer, and surface topography of a region of the doped semiconductor layer exposed at the opening is not limited. The specific surface topography is described in detail below.

Only a part different from that of the foregoing embodiment is described in this embodiment. For the same part, refer to the foregoing embodiment. For example, for a feature of the semiconductor substrate 11 in this embodiment, refer to the feature of the semiconductor substrate 11 in the foregoing embodiment, and details are not described herein again.

For example, the first doped semiconductor layer 12-1 may be an N-type doped semiconductor layer, and the second doped semiconductor layer 12-2 may be a P-type doped semiconductor layer. The first doped semiconductor layer 12-1 and the second doped semiconductor layer 12-2 in the present disclosure may be alternatively referred to as a first conductive doped layer and a second conductive doped layer.

The solar cell provided in this embodiment is a back contact cell, and the first doped semiconductor layer 12-1 and the second doped semiconductor layer 12-2 are alternately disposed on a side of the first surface of the semiconductor substrate 11. A conductivity type of the first doped semiconductor layer 12-1 may be the same as the conductivity type of the semiconductor substrate 11, and a conductivity type of the second doped semiconductor layer 12-2 is opposite to the conductivity type of the semiconductor substrate 11. Alternatively, a conductivity type of the first doped semiconductor layer 12-1 may be opposite to the conductivity type of the semiconductor substrate 11, and a conductivity type of the second doped semiconductor layer 12-2 is the same as the conductivity type of the semiconductor substrate 11.

For materials of the first doped semiconductor layer 12-1 and the second doped semiconductor layer 12-2, refer to the material of the doped semiconductor layer in the foregoing embodiment, and details are not described herein again. The materials of the first doped semiconductor layer 12-1 and the second doped semiconductor layer 12-2 may be the same or may be different.

In some examples, an isolation region is formed between the first doped semiconductor layer 12-1 and the second doped semiconductor layer 12-2, and the isolation region may be, for example, an isolation channel. In some other examples, there is no isolation region between the first doped semiconductor layer 12-1 and the second doped semiconductor layer 12-2, that is, the first doped semiconductor layer 12-1 and the second doped semiconductor layer 12-2 are disposed in connection, or there is an overlapping region between the first doped semiconductor layer 12-1 and the second doped semiconductor layer 12-2.

The dielectric layer 13 is disposed on a side of the first doped semiconductor layer 12-1 and the second doped semiconductor layer 12-2 facing away from the semiconductor substrate 11. The dielectric layer 13 includes a plurality of first openings 14-1 and a plurality of second openings 14-2. The first openings 14-1 expose a partial region of the first doped semiconductor layer 12-1, and the second openings 14-2 expose a partial region of the second doped semiconductor layer 12-2. The first opening 14-1 and the second opening 14-2 may also be referred to as a first conductive window and a second conductive window.

For a structural feature of the dielectric layer 13, refer to the dielectric layer 13 in the foregoing embodiment, and details are not described herein again.

In some embodiments, the solar cell may further include a first passivation layer 20 located between the semiconductor substrate 11 and the doped semiconductor layer (to be specific, the first doped semiconductor layer 12-1 and the second doped semiconductor layer 12-2), as shown in FIG. 7. The first passivation layer 20 may passivate at least a surface of the semiconductor substrate 11 corresponding to the doped semiconductor layer, and reduce a carrier recombination rate on the surface of the semiconductor substrate 11. In addition, the first doped semiconductor layer 12-1 and the second doped semiconductor layer 12-2 can respectively selectively collect carriers of a corresponding conductivity type in the semiconductor substrate 11, to further improve the photoelectric conversion efficiency of the solar cell provided in this embodiment of the present disclosure. In some of the implementations, the first passivation layer 20 formed between the semiconductor substrate 11 and the first doped semiconductor layer 12-1 and the first passivation layer 20 formed between the semiconductor substrate 11 and the second doped semiconductor layer 12-2 may be formed at the same time, or may be formed in different process steps. When formed in different process steps, the first passivation layer 20 formed between the semiconductor substrate 11 and the first doped semiconductor layer 12-1 and the first passivation layer 20 formed between the semiconductor substrate 11 and the second doped semiconductor layer 12-2 may have same or different materials, thicknesses, and the like.

The first passivation layer 20 may be one or more layers, or may be formed by different materials in different regions. The material of the first passivation layer 20 may be determined based on a material of the doped semiconductor layer. For example, when the first doped semiconductor layer and the second doped semiconductor layer are both doped polycrystalline silicon layers, the first passivation layer 20 may be a tunneling passivation layer. In this case, the first doped semiconductor layer and the first passivation layer 20 may form a tunneling passivation contact structure, and the second doped semiconductor layer and the first passivation layer may form a tunneling passivation contact structure. In addition, a material of the tunneling passivation layer may include any dielectric material having a tunneling passivation function. For example, for the material of the tunneling passivation layer, refer to the foregoing descriptions, and details are not described herein again.

In some implementations, the solar cell of this embodiment of the present disclosure may further include a surface passivation layer and an anti-reflection layer that are formed on a side of the semiconductor substrate 11 facing away from the doped semiconductor layer, that is, formed on the second surface. For materials and functions of the surface passivation layer and the anti-reflection layer, refer to the foregoing descriptions, and details are not described herein again.

For any one of the embodiments of the present disclosure, surface topography (for example, a roughness or a contact area between an electrode and the doped semiconductor layer) of a side of a part of the doped semiconductor layer exposed at the opening and facing away from the semiconductor substrate directly affects stability of a structure of the electrode. Therefore, a proper topographic feature can resolve or at least alleviate a problem that the electrode is easily separated from the doped semiconductor layer, thereby ensuring structural reliability of the solar cell.

It should be noted that, laser parameters such as laser energy, a spot size of the laser, an overlapping rate of laser spots, an irradiated area of the laser, and energy of the laser at different positions may be controlled to control the surface topography of the side of the part of the doped semiconductor layer exposed at the opening and facing away from the semiconductor substrate. It is clear that, the surface topography of the side of the part of the doped semiconductor layer exposed at the opening and facing away from the semiconductor substrate may alternatively be controlled by adjusting a composition of an etching solution and an etching condition such as a temperature and time.

For ease of description, the doped semiconductor layer in the following embodiment of the present disclosure may include one doped semiconductor layer, or may include at least one of the first doped semiconductor layer 12-1 and the second doped semiconductor layer 12-2, where a feature of the at least one of the first doped semiconductor layer 12-1 and the second doped semiconductor layer 12-2 is the same as a feature of the following doped semiconductor layer. The opening in the following embodiment of the present disclosure may include one opening, or may include at least one of the first opening 14-1 and the second opening 14-2, where a feature of the at least one of the first opening 14-1 and the second opening 14-2 is the same as a feature of the following opening. The hole in the following embodiment of the present disclosure may include one hole, or may include at least one of a first hole 15-1 and a second hole 15-2, where a feature of the at least one of the first hole 15-1 and the second hole 15-2 is the same as a feature of the following hole. The annular protrusion part in the following embodiment of the present disclosure may include one annular protrusion part, or may include at least one of an annular protrusion part 16-1 of the first hole and an annular protrusion part 16-2 of the second hole, where a feature of the at least one of the annular protrusion part 16-1 of the first hole and the annular protrusion part 16-2 of the second hole is the same as a feature of the following annular protrusion part.

Referring to FIG. 8-1 to FIG. 8-13, for any embodiment of the present disclosure, the side of the part of the doped semiconductor layer exposed at the opening and facing away from the semiconductor substrate may have one or more of the following topographic features.

For example, in the solar cell provided in the present disclosure, a plurality of holes 15 are formed on a side of a part of the doped semiconductor layer exposed at the opening and facing away from the semiconductor substrate. For effects of the plurality of holes 15 being formed on the side of the part of the doped semiconductor layer exposed at the opening and facing away from the semiconductor substrate, refer to the foregoing descriptions, and details are not described herein again. In some examples, an example in which the doped semiconductor layer is a P-type polycrystalline silicon layer is used. A contact resistance between an electrode and the doped semiconductor layer may be reduced to an average of 0.8 mΩ*cm2. An example in which the doped semiconductor layer is an N-type polycrystalline silicon layer is used. A contact resistance between an electrode and the doped semiconductor layer 12 may be reduced to an average of 0.35 mΩ*cm2.

It may be understood that a shape, a size, a quantity, and topography of the holes 15 may affect the surface roughness of the side of the part of the doped semiconductor layer exposed at the opening and facing away from the semiconductor substrate. Therefore, the foregoing related information of the holes may be adjusted according to an actual application scenario.

For example, the hole 15 is a semi-spherical hole. The semi-spherical hole may be a hemispherical hole in a strict sense, or may be an approximate hemispherical hole, that is, may have some small deformations relative to the hemispherical hole, for example, may have deformations within an allowed tolerance range (for example, within 5% or 10%) relative to the hemispherical hole. When the hole 15 is a semi-spherical hole, a cross sectional size of an entrance of the hole is the largest along a depth direction of the hole 15, so that it is convenient to fill the hole 15 with conductive materials used for manufacturing the electrode, and this is beneficial to improving connection strength and contact performance between the electrode and the doped semiconductor layer, and ensures a large binding force and good contact performance between the electrode and the doped semiconductor layer.

In some examples, a radial maximum dimension of the hole 15 is at a scale of nanometer. In this case, the radial maximum dimension of the hole is small, and this is beneficial to preventing a thickness of a remaining part from being small when the side of the part of the doped semiconductor layer exposed at the opening and facing away from the semiconductor substrate is provided with the holes on the surface, ensures that the doped semiconductor layer has a high carrier separating capability, reduces a carrier recombination rate, and further improves the photoelectric conversion efficiency of the solar cell.

In some other examples, a radial maximum dimension of the hole 15 is greater than 0 µm and less than or equal to 3 µm.

It is considered that if the radial maximum dimension of the hole 15 is excessively large, for example, is 4 µm, 5 µm, 10 µm, or greater, the quantity of the holes 15 may be reduced. In this way, a specific surface area of the part of the doped semiconductor layer exposed at the opening is reduced. Consequently, the contact area between the doped semiconductor layer and the electrode is reduced, and the binding force between the electrode and the doped semiconductor layer is reduced. Therefore, the radial maximum dimension of the hole 15 is less than or equal to 3 µm.

Further, it is considered that if the radial maximum dimension of the hole 15 is excessively small, the surface roughness of the doped semiconductor layer is small. Consequently, when the electrode is formed on the doped semiconductor layer, it is difficult to fill the hole 15 of the small size with conductive materials used for manufacturing the electrode, and the connection strength and the contact performance between the electrode and the doped semiconductor layer cannot be ensured. Therefore, in some examples, the radial maximum dimension of the hole is greater than or equal to 0.02 µm. Optionally, a radial maximum dimension of the hole is greater than or equal to 0.02 µm and less than or equal to 0.1 µm.

The radial maximum dimension of the hole 15 may be, for example, 0.02 µm, 0.03 µm, 0.04 µm, 0.05 µm, 0.06 µm, 0.07 µm, 0.08 µm, 0.09 µm, 0.1 µm, 0.4 µm, 0.5 µm, 0.7 µm, 0.9 µm, 1 µm, 1.5 µm, 2 µm, or 3 µm.

The range of the radial maximum dimension of the hole 15 used in the present disclosure helps increase the surface roughness of the doped semiconductor layer, increase the contact area between the electrode and the doped semiconductor layer, increase the binding force between the electrode and the doped semiconductor layer, enhance the connection strength between the two, and reduce the risk that the electrode is separated from the doped semiconductor layer, thereby helping improve the structural reliability of the solar cell.

For example, an annular protrusion part 16 is formed at an edge of the hole 15. As shown in FIG. 8-2, a circular (or circular-like) region surrounded by a bright circle is the hole 15, and the bright circle is an annular protrusion part 16 formed at an edge of the hole 15. In some examples, the annular protrusion part 16 may be formed by fusing and then solidifying materials of the doped semiconductor layer. Similar to a form of a circular crater, the annular protrusion part 16 is convex relative to a region inside the hole 15 and/or a region outside the hole 15.

It may be understood that, because the annular protrusion part 16 is formed by fusing and then solidifying the doped semiconductor layer, when the doped semiconductor layer is a doped polycrystalline silicon layer, a material of the annular protrusion part 16 includes silicon.

By using the foregoing technical solution, the annular protrusion part 16 can further enhance the bumpy surface feature formed on the side of the part of the doped semiconductor layer exposed at the opening and facing away from the semiconductor substrate, facilitating further increasing the surface roughness and the specific surface area of the side of the part of the doped semiconductor layer exposed at the opening and facing away from the semiconductor substrate. Based on this, because the electrode of the solar cell provided in this embodiment of the present disclosure is formed on the bumpy surface of the doped semiconductor layer, the contact area between the part of the doped semiconductor layer exposed at the opening and the electrode is increased. This helps increase the binding force between the electrode and the doped semiconductor layer, enhance the connection strength between the two, reduce the risk that the electrode is separated from the doped semiconductor layer, and improve the structural reliability of the solar cell. In addition, because the contact area between the part of the doped semiconductor layer exposed at the opening and the electrode is increased, the contact resistance between the doped semiconductor layer and the electrode can be lowered, the contact performance is improved, and the photoelectric conversion efficiency of the solar cell is further improved.

For example, a width of the annular protrusion part 16 is greater than 0 µm and less than or equal to 0.3 µm. It is considered that if the width of the annular protrusion part 16 is excessively large, for example, is 0.4 µm, 0.7 µm, 1 µm, or greater, the specific surface area of the doped semiconductor layer is not significantly increased, so that reduction of the surface roughness of the doped semiconductor layer is not beneficial to increasing the contact area between the electrode and the doped semiconductor layer. Therefore, the width of the annular protrusion part 16 in the present disclosure is less than or equal to 0.3 µm.

Further, it is considered that if the width of the annular protrusion part 16 is excessively small, the annular protrusion part is easily broken, which does not contribute to an increase in the contact area between the electrode and the doped semiconductor layer, and silicon in the annular protrusion part 16 (that is, the silicon in the doped semiconductor layer) is easily pulled off by the electrode, which is not beneficial to an increase in the bonding force between the electrode and the doped semiconductor layer. Therefore, in some examples, the width of the annular protrusion part 16 is greater than or equal to 0.05 µm.

The width of the annular protrusion part 16 may be, for example, 0.05 µm, 0.07 µm, 0.09 µm, 0.1 µm, 0.15 µm, 0.2 µm, or 0.3 µm.

The range of the width of the annular protrusion part 16 helps increase the surface roughness of the doped semiconductor layer, thereby helping increase the contact area between the electrode and the doped semiconductor layer, increase the binding force between the electrode and the doped semiconductor layer, enhance the connection strength between the two, reduce the risk that the electrode is separated from the doped semiconductor layer, and improve the structural reliability of the solar cell.

For example, a height of the annular protrusion part 16 is greater than 0 µm and less than or equal to 0.5 µm. It is considered that if the height of the annular protrusion part 16 is excessively large, for example, is 0.6 µm, 0.8 µm, 1 µm, or greater, the annular protrusion part 16 is easily broken, which does not contribute to the increase in the contact area between the electrode and the doped semiconductor layer, and the annular protrusion part 16 is easily broken by the electrode. Consequently, a pulling force between the electrode and the doped semiconductor layer is reduced, which is not beneficial to increasing the bonding force between the electrode and the doped semiconductor layer. Therefore, the height of the annular protrusion part 16 in the present disclosure is less than or equal to 0.5 µm.

Further, it is considered that if the height of the annular protrusion part 16 is excessively small, it is not beneficial to increasing the surface roughness of the doped semiconductor layer. Therefore, in some examples, the height of the annular protrusion part 16 is greater than or equal to 0.001 µm.

The height of the annular protrusion part 16 may be, for example, 0.001 µm, 0.005 µm, 0.008 µm, 0.01 µm, 0.05 µm, 0.6 µm, 0.07 µm, 0.08 µm, 0.09 µm, 0.1 µm, 0.2 µm, 0.3 µm, or 0.5 µm.

The range of the height of the annular protrusion part 16 helps increase the surface roughness of the doped semiconductor layer, thereby helping increase the contact area between the electrode and the doped semiconductor layer, increase the binding force between the electrode and the doped semiconductor layer, enhance the connection strength between the two, reduce the risk that the electrode is separated from the doped semiconductor layer, and improve the structural reliability of the solar cell.

For example, a range of a ratio of a radial maximum dimension of the hole 15 to a width of the annular protrusion part is less than or equal to 60. It is considered that if the ratio is excessively large, for example, is 80, 90, 100, or greater, that is, the radial maximum dimension of the hole 15 is large, the width of the annular protrusion part 16 is small. If the radial maximum dimension of the hole 15 is large, the quantity of the holes 15 is reduced, and the width of the annular protrusion part 16 is small. Consequently, the specific surface area of the doped semiconductor layer at the opening is reduced, the surface roughness of the doped semiconductor layer at the opening is reduced, and it is not beneficial to increasing the contact area between the electrode and the doped semiconductor layer. Therefore, the range of the ratio of the radial maximum dimension of the hole 15 to the width of the annular protrusion part 16 is less than or equal to 60.

Further, it is considered that if the ratio is excessively small, that is, the width of the annular protrusion part 16 is large, and the radial maximum dimension of the hole 15 is small, the specific surface area of the doped semiconductor layer is also reduced. Consequently, the surface roughness of the doped semiconductor layer is reduced, and it is not beneficial to increasing the contact area between the electrode and the doped semiconductor layer. In addition, if the radial maximum dimension of the hole 15 is small, the surface roughness of the doped semiconductor layer is small. Consequently, when the electrode is formed on the doped semiconductor layer, it is difficult to fill the hole 15 of the small size with conductive materials used for manufacturing the electrode, and the connection strength and the contact performance between the electrode and the doped semiconductor layer cannot be ensured. Therefore, in some examples, the ratio of the radial maximum dimension of the hole to the width of the annular protrusion part is greater than or equal to 0.06.

The range of the ratio of the radial maximum dimension of the hole 15 to the width of the annular protrusion part 16 may be, for example, 0.06, 0.08, 0.1, 0.2, 0.3, 1, 10, 15, 18, 20, 30, 35, 40, or 60.

The range of the ratio of the radial maximum dimension of the hole 15 to the width of the annular protrusion part 16 helps increase the surface roughness of the doped semiconductor layer, increase the contact area between the electrode and the doped semiconductor layer, increase the binding force between the electrode and the doped semiconductor layer, enhance the connection strength between the two, and reduce the risk that the electrode is separated from the doped semiconductor layer, thereby helping improve the structural reliability of the solar cell.

For example, a doping concentration of a side of the doped semiconductor layer located at the opening away from the semiconductor substrate is greater than a doping concentration of a side close to the semiconductor substrate.

By using the foregoing technical solution, because the doping concentration of the doped semiconductor layer away from the semiconductor substrate is increased, that is, the doping concentration of the doped semiconductor layer on the side close to the electrode is larger, the contact resistance between the doped semiconductor layer and the electrode can be lowered, and the photoelectric conversion efficiency of the solar cell can be improved. In addition, compared with a case in which the doping concentration on the side of the doped semiconductor layer close to the electrode is the same as the doping concentration on the side of the doped semiconductor layer close to the semiconductor substrate, because the doping concentration on the side of the doped semiconductor layer close to the electrode is larger, a thickness of the doped semiconductor layer can be suitably reduced. In this way, costs can be reduced, and manufacturing efficiency of the solar cell can also be improved.

For example, the side of the part of the doped semiconductor layer exposed at the opening and facing away from the semiconductor substrate has a fifth surface roughness, a side of a part of the doped semiconductor layer not exposed at the opening and facing away from the semiconductor substrate has a sixth surface roughness, and the fifth surface roughness is greater than the sixth surface roughness. The surface roughness of the part of the doped semiconductor layer exposed at the opening is large, so that the contact area between the doped semiconductor layer and the electrode can be increased. This helps reduce the contact resistance between the electrode and the doped semiconductor layer, and helps increase the binding force between the electrode and the doped semiconductor layer, enhance the connection strength between the two, reduce the risk that the electrode is separated from the doped semiconductor layer, and improve the structural reliability of the solar cell. Moreover, the sixth surface roughness is small, and this can ensure good film forming quality of the formed doped semiconductor layer.

For example, the fifth surface roughness ranges from 0 µm to 0.5 µm. In some embodiments, the fifth surface roughness ranges from 0.3 µm to 0.5 µm. For example, the fifth surface roughness may be 0.3 µm, 0.35 µm, 0.4 µm, 0.45 µm, or 0.5 µm; and the sixth surface roughness ranges from 0 µm to 100 µm. In this case, if the fifth surface roughness is within the foregoing range, a contact area between the electrode and the side of the doped semiconductor layer exposed at the opening and facing away from the semiconductor substrate can be ensured, and high connection strength and good contact performance between the electrode and the doped semiconductor layer can be ensured.

For example, the side of the part of the doped semiconductor layer exposed at the opening and facing away from the semiconductor substrate has the fifth surface roughness, and a non-exposed part of the doped semiconductor layer not exposed at the opening includes a first non-exposed part at an edge of the opening of the dielectric layer and a remaining non-exposed part other than the first non-exposed part. A side of the first non-exposed part facing away from the semiconductor substrate has a seventh surface roughness, and a side of the remaining non-exposed part facing away from the semiconductor substrate has an eighth surface roughness, where the fifth surface roughness > the seventh surface roughness > the eighth surface roughness. The surface roughness of the part of the doped semiconductor layer exposed at the opening is large, so that the contact area between the doped semiconductor layer and the electrode can be increased, and this helps to reduce the contact resistance between the electrode and the doped semiconductor layer, helps increase the binding force between the electrode and the doped semiconductor layer, enhance the connection strength between the two, reduce the risk that the electrode is separated from the doped semiconductor layer, and improve the structural reliability of the solar cell. In addition, when the electrode is formed, a material of the electrode may be formed on the first non-exposed part. Therefore, the seventh surface roughness of the first non-exposed part is larger than the eighth surface roughness. This can further enhance the binding force between the electrode and the doped semiconductor layer, to help reduce the risk that the electrode is separated from the doped semiconductor layer, thereby improving the structural stability of the solar cell.

In this embodiment of the present disclosure, the surface roughness may refer to an arithmetic average deviation Ra of a contour of a targeted surface, and specifically refers to an arithmetic mean of absolute values of peak and valley (relative to an average line) of the contour of the surface within a sampling length Lr of the targeted surface. During actual measurement, a larger quantity of measurement points indicates more accurate Ra. Alternatively, the surface roughness may refer to a maximum height Rz of the contour of the targeted surface, and specifically refers to a distance between a peak line and a valley line of the contour of the targeted surface. It may be understood that, when roughness of different surface regions is involved, for example, when the first surface roughness, the second surface roughness, the third surface roughness, and the fourth surface roughness are involved, a same roughness measurement standard is used.

For example, a plurality of discontinuous protrusion parts 21 are also formed on the side of the part of the doped semiconductor layer exposed at the opening and facing away from the semiconductor substrate. The discontinuous protrusion part 21 may include at least one of a dotted protrusion (such as a bright dot in a circle mark in FIG. 8-2) and a linear protrusion (such as a white curve in a square box in FIG. 8-2). The linear protrusion may be a straight linear protrusion, a curved linear protrusion, an unclosed loop protrusion, or the like.

The discontinuous protrusion part 21 may be distributed at any position on the side of the part of the doped semiconductor layer exposed at the opening and facing away from the semiconductor substrate. The discontinuous protrusion part 21 also helps increase the surface roughness of the doped semiconductor layer at the opening, thereby further increasing the contact area between the electrode and the doped semiconductor layer, increasing the binding force between the electrode and the doped semiconductor layer, enhancing the connection strength between the two, reducing the risk that the electrode is separated from the doped semiconductor layer, and improving the structural reliability of the solar cell.

In this embodiment of the present disclosure, a quantity of discontinuous protrusion parts per unit area located in an edge region of the opening is greater than a quantity of discontinuous protrusion parts per unit area located in a middle region of the opening; or a quantity of discontinuous protrusion parts per unit area located in an edge region of the opening is less than a quantity of discontinuous protrusion parts per unit area located in a middle region of the opening. The opening in the present disclosure may be of a shape such as a circle, a square, or an ellipse. Correspondingly, a shape formed by a boundary of the middle region of the opening is the same as a shape formed by a boundary of the opening, and a distance between the boundary of the middle region and the boundary of the opening is equal or approximately equal. For example, when the opening is a circle, the middle region is a circular or approximately circular region surrounding a center of the opening, and in a radial direction passing through the center of the opening, distances from the boundary of the middle region to the outer boundary of the opening are the same or nearly the same (that is, are equal within a tolerance allowance). A region other than the middle region inside the opening is the edge region of the opening. The approximately circular region means that that shape may have some small deformation relative to a circle, for example, deformation within a tolerance allowance range (for example, within 5% or 10%) relative to a circle. As shown in FIG. 8-2, a region surrounded by a large red circle in the figure is the middle region of the opening, and the remaining part is the edge region of the opening.

For example, when the doped semiconductor layer is a P-type doped semiconductor layer, as shown in FIG. 8-4, a quantity of discontinuous protrusion parts per unit area located in an edge region of the opening is greater than a quantity of discontinuous protrusion parts per unit area located in a middle region of the opening. Usually, because the P-type doped semiconductor layer has a low doping concentration, and the P-type doped semiconductor layer has an attribute that there are many holes and few electrons, it is not beneficial to forming an electrode on the P-type doped semiconductor layer. It may be understood that, when electrodes of a same thickness are formed, difficulty in manufacturing an electrode on the P-type doped semiconductor layer is greater than difficulty in manufacturing an electrode on an N-type doped semiconductor layer. In addition, for an opening, difficulty in manufacturing an electrode in an edge region of the opening is greater than difficulty in manufacturing an electrode in a middle region of the opening. Based on this, in some embodiments of the present disclosure, the quantity of discontinuous protrusion parts of the P-type doped semiconductor layer located per unit area of the edge region of the opening is greater than the quantity of discontinuous protrusion parts of the P-type doped semiconductor layer located per unit area of the middle region of the opening. In this way, a manufacturing effect of the electrode in the edge region of the opening can be improved, and quality of the electrode formed in the edge region of the opening is ensured, so that the quality of the electrode formed in the edge region of the opening and quality of the electrode formed in the middle region tends to be consistent, which helps improve carrier transmission effect in the electrode.

For example, when the doped semiconductor layer is an N-type doped semiconductor layer, as shown in FIG. 8-3, a quantity of discontinuous protrusion parts per unit area located in a middle region of the opening is greater than a quantity of discontinuous protrusion parts per unit area located in an edge region of the opening. Usually, because the N-type doped semiconductor layer has a high doping concentration, and the N-type doped semiconductor layer has an attribute that there are many electrons and few holes, it is beneficial to forming an electrode on the N-type doped semiconductor layer. It may be understood that, when electrodes of a same thickness are formed, the difficulty in manufacturing an electrode on the N-type doped semiconductor layer is less than the difficulty in manufacturing an electrode on the P-type doped semiconductor layer. In addition, for an opening, because the difficulty in manufacturing an electrode in the middle region of the opening is less than the difficulty in manufacturing an electrode in the edge region of the opening, in other words, it is less difficult to manufacture the electrode in the middle region of the N-type doped semiconductor layer, so that a speed of manufacturing the electrode in the middle region of the N-type doped semiconductor layer is higher, but an excessively high electrode manufacturing speed does not help improve the adhesion. Therefore, in some embodiments of the present disclosure, it is set that the quantity of discontinuous protrusion parts of the N-type doped semiconductor layer located per unit area of the middle region of the opening is larger than the quantity of discontinuous protrusion parts located per unit area of the edge region of the opening, so that a specific surface area of the middle region of the N-type doped semiconductor layer can be increased, thereby helping improve the binding force between the electrode in the middle region and the N-type doped semiconductor layer.

For example, a height of the discontinuous protrusion part is greater than 0 µm and less than or equal to 0.5 µm. It is considered that if the height of the discontinuous protrusion part is excessively high, the discontinuous protrusion part is easily broken, and a pulling force between the electrode and the doped semiconductor layer is reduced. Therefore, the height of the discontinuous protrusion part in the present disclosure is less than or equal to 0.5 µm.

Further, it is considered that if the height of the discontinuous protrusion part is excessively small, contribution to the increase of the surface roughness of the doped semiconductor layer is not large. Therefore, in some examples, the height of the discontinuous protrusion part is greater than or equal to 0.001 µm.

The height of the discontinuous protrusion part may be, for example, 0.001 µm, 0.003 µm, 0.006 µm, 0.009 µm, 0.01 µm, 0.05 µm, 0.07 µm, 0.1 µm, 0.2 µm, 0.3 µm, or 0.5 µm.

The range of the height of the discontinuous protrusion part in the present disclosure helps to increase the surface roughness of the doped semiconductor layer, thereby increasing the contact area between the electrode and the doped semiconductor layer, increasing the binding force between the electrode and the doped semiconductor layer, enhancing the connection strength between the two, and additionally avoiding a problem that a pulling force between the electrode and the doped semiconductor layer is reduced due to the excessively large height.

For the back contact cells shown in FIG. 4 to FIG. 7, because the P-type doped semiconductor layer and the N-type doped semiconductor layer have different materials, doping concentrations, and electrical conductivities, a contact resistance and a binding force between the P-type doped semiconductor layer and the first electrode are also different from a contact resistance and a binding between the N-type doped semiconductor layer and the second electrode. Currently, it is difficult for the contact resistances and the binding forces between the P-type doped semiconductor layer and the first electrode and between the N-type doped semiconductor layer and the second electrode to satisfy requirements. Therefore, it is difficult to better match a P region and an N region in terms of electric performance and the pulling force.

For the foregoing problem, the embodiments of the present disclosure provide a resolving solution. Referring to FIG. 8-2 to FIG. 8-10, in the back contact solar cell of this embodiment, the dielectric layer includes a plurality of first openings and a plurality of second openings. The first opening exposes a partial region of the first doped semiconductor layer, and the second opening exposes a partial region of the second doped semiconductor layer. A region of the first doped semiconductor layer exposed at the first opening has a first surface roughness, a region of the second doped semiconductor layer exposed at the second opening has a second surface roughness, and the first surface roughness is different from the second surface roughness.

Using the first surface roughness as an example, the first surface roughness of the region of the first doped semiconductor layer exposed at the first opening affects a contact area between the first electrode formed in the region at the first opening and the first doped semiconductor layer, and further affects the contact resistance between the first electrode and the first doped semiconductor layer, the binding force between the first electrode and the first doped semiconductor layer, and film forming quality of the first electrode. The contact resistance between the first electrode and the first doped semiconductor layer and the binding force between the first electrode and the first doped semiconductor layer further affect a quantity of first openings. Therefore, the first surface roughness may be adjusted, to adjust the contact resistance and the binding force between the first electrode and the first doped semiconductor layer, the film forming quality of the first electrode, the quantity of the first openings, and the like.

By using the foregoing technical solution, because the region of the first doped semiconductor layer exposed at the first opening has the first surface roughness, and the first surface roughness can increase the contact area between the first electrode and the first doped semiconductor layer, the binding force between the first electrode and the first doped semiconductor layer can be increased, and a contact resistance between the first electrode and the second doped semiconductor layer can be reduced. The region of the second doped semiconductor layer exposed at the second opening has the second surface roughness, and the second surface roughness has the same technical effects as those of the first surface roughness. Details are not described herein again. In addition, the first surface roughness of the region of the first doped semiconductor layer exposed at the first opening is different from the second surface roughness of the region of the second doped semiconductor layer exposed at the second opening. Therefore, the first surface roughness and the second surface roughness may be adjusted, to adjust film forming quality of the first electrode and the second electrode, contact resistances and binding forces between the first electrode and the first doped semiconductor layer and between the second electrode and the second doped semiconductor layer, quantities of the first openings and the second openings, and the like, to alleviate a problem of mismatching between the quantities of the first openings and the second openings, the film forming quality of the first electrode and the second electrode, the contact resistances and the binding forces between the first electrode and the first doped semiconductor layer and between the second electrode and the second doped semiconductor layer, caused by different materials, different doping concentrations, and different electrical conductivities of the first doped semiconductor layer and the second doped semiconductor layer. This facilitates making the contact resistances and the binding forces between the first electrode and the first doped semiconductor layer and between the second electrode and the second doped semiconductor layer, and the quantities of the first openings and the second openings satisfy a design requirement of the solar cell, and making the film forming quality of the first electrode and the second electrode also satisfy the design of the solar cell, thereby further helping improve the structural stability of the Solar cell. In addition, in a manufacturing process of the solar cell, the P region and the N region of the solar cell may further be effectively identified based on different surface roughness. In addition, compared with a case in which the electrode is directly formed by using a high-temperature sintering process, the electrode in the present disclosure can be formed at the opening by using a low-temperature metallization process, and costs of the metallization process can be reduced.

For example, the first surface roughness is greater than the second surface roughness. FIG. 8-5 shows a surface of the region of the first doped semiconductor layer exposed at the first opening, and the surface has the first surface roughness. FIG. 8-6 shows a surface of the region of the second doped semiconductor layer exposed at the second opening, and the surface has the second surface roughness. It can be seen by comparing FIG. 8-5 and FIG. 8-6 that, the first surface roughness is greater than the second surface roughness.

By using the foregoing technical solution, the first surface roughness is a surface roughness of the region of the first doped semiconductor layer exposed at the first opening, that is, a surface roughness of a region of the N-type doped semiconductor layer exposed at the first opening. According to this embodiment of the present disclosure, the first surface roughness is increased, so that the contact area between the N-type doped semiconductor layer and the electrode can be increased, the contact resistance between the N-type doped semiconductor layer and the electrode can be lowered, and the binding force between the N-type doped semiconductor layer and the electrode can be improved. In some examples, the contact resistance between the N-type doped semiconductor layer and the electrode is low, and the binding force between the N-type doped semiconductor layer and the electrode is high. Therefore, on the premise that requirements on the binding force and the contact resistance are satisfied, the quantity of the first openings in the N region corresponding to the N-type doped semiconductor layer can be reduced, in other words, the quantity of the first openings is less than the quantity of the second openings. In this way, reducing the quantity of the first openings can improve efficiency of forming the first opening on the dielectric layer, and can further reduce damage to the N-type doped semiconductor layer caused by opening a mold by using laser, thereby helping ensure a passivation effect of the N region.

In some implementations, the first surface roughness is less than the second surface roughness. FIG. 8-7 shows a surface of the region of the first doped semiconductor layer exposed at the first opening, and the surface has the first surface roughness. FIG. 8-8 shows a surface of the region of the second doped semiconductor layer exposed at the second opening, and the surface has the second surface roughness. It can be seen by comparing FIG. 8-7 and FIG. 8-8 that, the first surface roughness is less than the second surface roughness.

The second surface roughness is a surface roughness of the region of the second doped semiconductor layer (namely, the P-type doped semiconductor layer in this embodiment) exposed at the second opening. Because an electrical conductivity of the P-type doped semiconductor layer is greater than an electrical conductivity of the N-type doped semiconductor layer, that is, the electrical conductivity of the P-type doped semiconductor layer is higher, a contact resistance between the P-type doped semiconductor layer and the second electrode is larger. Therefore, the second surface roughness corresponding to the P-type doped semiconductor layer may be increased in this embodiment of the present disclosure, so that a contact area between the P-type doped semiconductor layer and the second electrode can be increased, and a contact resistance between the P-type doped semiconductor layer and the second electrode can be reduced, thereby helping improve the photoelectric conversion efficiency of the solar cell. Further, a binding force between the P-type doped semiconductor layer and the electrode can be enhanced, further enhancing connection strength between the P-type doped semiconductor layer and the electrode, reducing a risk of the electrode falling off from the P-type doped semiconductor layer, and improving the structural reliability of the solar cell.

It should be noted that, laser parameters such as laser energy, a spot size of the laser, an overlapping rate of laser spots, an irradiated area of the laser, and energy of the laser at different positions may be controlled, or a composition, a concentration, time, and the like of a corrosion solution may be controlled, to control the first surface roughness and the second surface roughness.

For example, a region of the first doped semiconductor layer covered by the dielectric layer has a third surface roughness, and the first surface roughness is greater than the third surface roughness.

In this embodiment of the present disclosure, the foregoing technical solution is used to increase the surface roughness of the part of the first doped semiconductor layer exposed at the opening, so that a contact area between the first doped semiconductor layer and the first electrode can be increased, and this helps to reduce a contact resistance between the first electrode and the doped semiconductor layer, increase a binding force between the first electrode and the first doped semiconductor layer, enhance connection strength between the two, reduce a risk that the first electrode is separated from the first doped semiconductor layer, and improve the structural reliability of the solar cell. In addition, the third surface roughness of the region of the first doped semiconductor layer covered by the dielectric layer is set to be small, so that it can be ensured that film forming quality of the dielectric layer formed on the first doped semiconductor layer is good, and the dielectric layer has a good passivation effect on the first doped semiconductor layer.

For example, a region of the second doped semiconductor layer covered by the dielectric layer has a fourth surface roughness, and the second surface roughness is greater than the fourth surface roughness. For the technical effects, refer to the technical effects corresponding to the first surface roughness being greater than the third surface roughness.

For example, a region of the first doped semiconductor layer covered by the dielectric layer has a third surface roughness, a region of the second doped semiconductor layer covered by the dielectric layer has a fourth surface roughness, and the third surface roughness is less than the fourth surface roughness.

The third surface roughness is a surface roughness of the region of the first doped semiconductor layer (namely, the N-type doped semiconductor layer in this embodiment) covered by the dielectric layer, and the fourth surface roughness is a surface roughness of the region of the second doped semiconductor layer (namely, the P-type doped semiconductor layer in this embodiment) covered by the dielectric layer. It may be understood that, usually, a doping concentration of the P-type doped semiconductor layer is lower than a doping concentration of the N-type doped semiconductor layer, that is, the second doped semiconductor layer has a lower doping concentration than the first doped semiconductor layer. Therefore, an electrical connectivity of the P-type doped semiconductor layer is greater than an electrical connectivity of the N-type doped semiconductor layer. When the third surface roughness is the same as the fourth surface roughness, the contact resistance between the P-type doped semiconductor layer and the second electrode is greater than the contact resistance between the N-type doped semiconductor layer and the first electrode. To make contact resistances of the P region and the N region the same or close, so as to make the solar cell have good photoelectric conversion efficiency, the fourth surface roughness is made to be greater than the third surface roughness. In this way, the contact area between the second doped semiconductor layer and the second electrode can be increased, and the contact resistance between the P-type doped semiconductor layer and the second electrode can be lowered.

For example, a method for implementing the first surface roughness being different from the second surface roughness includes: A plurality of first holes 15-1 are formed in the region of the first doped semiconductor layer exposed at the first opening, a plurality of second holes 15-2 are formed in the region of the second doped semiconductor layer exposed at the second opening, annular protrusion parts are formed at each of an edge of the first hole 15-1 and an edge of the second hole 15-2, and an average height of an annular protrusion part 16-1 of the first hole is different from an average height of an annular protrusion part 16-2 of the second hole. As shown in FIG. 8-3, a circular (or circular-like) region surrounded by a bright circle is the first hole 15-1, and the bright circle is an annular protrusion part 16-1 formed at an edge of the first hole 15-1; and as shown in FIG. 8-4, a circular (or circular-like) region surrounded by a bright circle is the second hole 15-2, and the bright circle is an annular protrusion part 16-2 formed at an edge of the second hole 15-2.

Features of the first hole 15-1, the second hole 15-2, the annular protrusion part 16-1 of the first hole, and the annular protrusion part 16-2 of the second hole are the same as the descriptions in the foregoing embodiment, and details are not described herein again.

It should be noted that, in this embodiment of the present disclosure, the first hole 15-1 does not penetrate the first doped semiconductor layer 12-1, and is a blind hole. Similarly, the second hole 15-2 does not penetrate the second doped semiconductor layer 12-2, and is a blind hole.

By using the foregoing technical solution in this embodiment of the present disclosure, the surface roughness of the regions of the openings (including the region of the first opening and the region of the second opening) can be adjusted by using the hole and the annular protrusion part, so that a bumpy surface feature can be formed on a side of the region of the doped semiconductor layer exposed at the opening and facing away from the semiconductor substrate, facilitating increasing the surface roughness and the specific surface area. Based on this, because when the electrode (including the first electrode and the second electrode) of the solar cell provided in this embodiment of the present disclosure is formed on the bumpy surface of the doped semiconductor layer, the contact area between the part of the doped semiconductor layer exposed at the opening and the electrode is increased, this helps increase the binding force between the electrode and the doped semiconductor layer, enhance the connection strength between the two, reduce the risk that the electrode is separated from the doped semiconductor layer, and improve the structural reliability of the solar cell. Further, the contact area between the part of the doped semiconductor layer exposed at the opening and the electrode is increased, helping lower the contact resistance between the electrode and the doped semiconductor layer, and improve the photoelectric conversion efficiency of the solar cell. In addition, different average heights of the annular protrusion parts lead to different surface roughness of the region of the first opening and the region of the second opening. Therefore, the average height of the annular protrusion parts may be adjusted to adjust the first surface roughness and the second surface roughness, to achieve the foregoing technical effect that the first surface roughness and the second surface roughness are different. Refer to the foregoing descriptions, and details are not described herein again.

For example, the average height of the annular protrusion parts may be measured by using the following method: separately selecting annular protrusion parts of a same quantity at same or nearly same positions in the region of the first opening and in the region of the second opening, and calculating an average value of heights of the annular protrusion parts, to obtain an average height of annular protrusion parts of the first hole and annular protrusion parts of the second hole. In this regard, for example, when a distance between a position of the region of the first opening and a center of the region of the first opening is equal to a distance between a position of the region of the second opening and a center of the region of the second opening, the position of the region of the first opening and the position of the region of the second opening constitute the same positions respectively in the region of the first opening and the region of the second opening. When a difference between the distance between the position of the region of the first opening and the center of the region of the first opening and the distance between the position of the region of the second opening and the center of the region of the second opening is less than a distance value or an allowable deviation, the position of the region of the first opening and the position of the region of the second opening separately constitute nearly the same positions in the region of the first opening and the region of the second opening.

For example, an average height of annular protrusion parts 16-1 of the first hole is greater than an average height of annular protrusion parts 16-2 of the second hole.

By using the foregoing technical solution, the average height of the annular protrusion parts 16-1 of the first hole is increased, so that the surface roughness of the region of the N-type doped semiconductor layer corresponding to the first hole exposed at the first opening can be increased, the contact area between the N-type doped semiconductor layer and the first electrode can be increased, the contact resistance between the N-type doped semiconductor layer and the first electrode can be lowered, and the binding force between the N-type doped semiconductor layer and the first electrode can be improved. In some examples, the contact resistance between the N-type doped semiconductor layer and the first electrode is low, and the binding force between the N-type doped semiconductor layer and the first electrode is high. Therefore, on the premise that requirements on the binding force and the contact resistance are satisfied, the quantity of the first openings in the N region corresponding to the N-type doped semiconductor layer can be reduced, in other words, the quantity of the first openings is less than the quantity of the second openings. In this way, reducing the quantity of the first openings can reduce damage to the N-type doped semiconductor layer caused by opening a mold by using laser, thereby helping ensure a passivation effect of the N region.

For example, the average height of the annular protrusion parts 16-2 of the second hole is greater than an average height of the annular protrusion parts 16-1 of the first hole.

By using the foregoing technical solution, the average height of the annular protrusion parts 16-2 of the second hole is greater than the average height of the annular protrusion parts 16-1 of the first hole, so that the second surface roughness of the region of the P-type doped semiconductor layer corresponding to the second hole exposed at the second opening is greater than the first surface roughness of the region of the N-type doped semiconductor layer corresponding to the first hole exposed at the first opening. Because an electrical conductivity of the P-type doped semiconductor layer is greater than an electrical conductivity of the N-type doped semiconductor layer, that is, the electrical conductivity of the P-type doped semiconductor layer is higher, a contact resistance between the P-type doped semiconductor layer and the second electrode is larger. Therefore, the second surface roughness corresponding to the P-type doped semiconductor layer may be increased in this embodiment of the present disclosure, so that a contact area between the P-type doped semiconductor layer and the second electrode can be increased, and a contact resistance between the P-type doped semiconductor layer and the second electrode can be reduced, thereby helping improve the photoelectric conversion efficiency of the solar cell. Further, a binding force between the P-type doped semiconductor layer and the electrode can be enhanced, further enhancing connection strength between the P-type doped semiconductor layer and the electrode, reducing a risk of the electrode falling off from the P-type doped semiconductor layer, and improving the structural reliability of the solar cell.

For example, a plurality of first holes 15-1 are formed in the region of the first doped semiconductor layer exposed at the first opening 14-1, and a plurality of second holes 15-2 are formed in the region of the second doped semiconductor layer exposed at the second opening 14-2; where a quantity of second holes 15-2 per unit area located in a middle region of the second opening 14-2 is greater than a quantity of first holes 15-1 per unit area located in a middle region of the first opening 14-1.

For example, as shown in FIG. 8-3 and FIG. 8-4, regions surrounded by two large red circles in the figures are the middle region of the first opening 14-1 and the middle region of the second opening 14-2, and the remaining part is the edge region of the opening. It can be seen from the two figures that, the quantity of the second holes 15-2 per unit area in the middle region of the second opening 14-2 is greater than the quantity of the first holes 15-1 per unit area in the middle region of the first opening 14-1.

Because the electrical connectivity of the P-type doped semiconductor layer is greater than the electrical connectivity of the N-type doped semiconductor layer, the contact resistance between the P-type doped semiconductor layer and the second electrode is large. In addition, when the electrode is in contact with the doped semiconductor layer at the opening, a pulling force on the electrode is mainly concentrated in the middle region of the opening, and a large quantity of holes are provided per unit area in the middle region of the second opening, which facilitates increasing the roughness of the middle region of the second opening, and further facilitates increasing the contact area between the second electrode and the second doped semiconductor layer in the middle region of the second opening, reduces the contact resistance between the P-type doped semiconductor layer and the second electrode, and facilitates improving the photoelectric conversion efficiency of the solar cell. Further, a binding force between the second electrode and the second doped semiconductor layer can be enhanced, enhancing connection strength between the two, reducing a risk of the electrode falling off from the P-type doped semiconductor layer, and improving the structural reliability of the solar cell.

It may be understood that in different embodiments, for example, under different laser conditions, a quantity of first holes per unit area located in the middle region of the first opening may alternatively be greater than a quantity of second holes per unit area located in the middle region of the second opening.

For example, a plurality of first holes 15-1 are formed in the region of the first doped semiconductor layer exposed at the first opening 14-1, and a plurality of second holes 15-2 are formed in the region of the second doped semiconductor layer exposed at the second opening 14-2; where an average radial maximum dimension of holes located in a middle region of the second opening 14-2 is greater than an average radial maximum dimension of holes located in a middle region of the first opening 14-1. For example, the average radial maximum dimension may be measured by using the following method: separately selecting first holes and second holes of a same quantity at same or nearly same positions in the region of the first hole and the region of the second hole, and calculating an average value of radial maximum dimensions of the first holes and the second holes, to obtain an average radial maximum dimension of the first holes and the second holes.

Still referring to FIG. 8-3 and FIG. 8-4, it can be seen from the figures that, an average radial maximum dimension of holes in the middle region of the second opening 14-2 is greater than an average radial maximum dimension of holes in the middle region of the first opening 14-1.

Because an electrical conductivity of the P-type doped semiconductor layer is greater than an electrical conductivity of the N-type doped semiconductor layer, that is, the electrical conductivity of the P-type doped semiconductor layer is higher, a contact resistance between the P-type doped semiconductor layer and the second electrode is larger. Therefore, an average radial maximum dimension of holes in the middle region of the second opening corresponding to the P-type doped semiconductor layer may be increased in this embodiment of the present disclosure, so that the second surface roughness corresponding to the P-type doped semiconductor layer is increased, a contact area between the P-type doped semiconductor layer and the second electrode can be increased, and a contact resistance between the P-type doped semiconductor layer and the second electrode can be reduced, thereby helping improve the photoelectric conversion efficiency of the solar cell. Further, a binding force between the P-type doped semiconductor layer and the electrode can be enhanced, further enhancing connection strength between the P-type doped semiconductor layer and the electrode, reducing a risk of the electrode falling off from the P-type doped semiconductor layer, and improving the structural reliability of the solar cell.

It may be understood that in different embodiments, for example, under different laser conditions, an average radial maximum dimension of holes in the middle region of the first opening may alternatively be greater than an average radial maximum dimension of holes in the middle region of the second opening.

For example, a doping concentration of a side of the first doped semiconductor layer located at the first opening 14-1 away from the semiconductor substrate is greater than a doping concentration of a side close to the semiconductor substrate; and/or a doping concentration of a side of the second doped semiconductor layer located at the second opening 14-2 away from the semiconductor substrate is greater than a doping concentration of a side close to the semiconductor substrate. For an effect of this example, refer to an effect of the doping concentration of the side of the doped semiconductor layer located at the opening away from the semiconductor substrate being greater than the doping concentration of the side close to the semiconductor substrate. Details are not described again herein.

For example, referring to FIG. 8-9 and FIG. 8-10, a difference between a doping concentration on a side of the first doped semiconductor layer located at the first opening 14-1 away from the semiconductor substrate and a doping concentration of a side close to the semiconductor substrate is a first difference; a difference between a doping concentration of a side of the second doped semiconductor layer located at the second opening 14-2 away from the semiconductor substrate and a doping concentration of a side close to the semiconductor substrate is a second difference; and the first difference is greater than the second difference. The horizontal coordinate in FIG. 8-9 indicates a depth of the first doped semiconductor layer along a direction from a surface of the first doped semiconductor layer close to the first electrode to a surface of the first doped semiconductor layer close to the semiconductor substrate, and the vertical coordinate indicates a doping concentration of the first doped semiconductor layer. The horizontal coordinate in FIG. 8-10 indicates a depth of the second doped semiconductor layer along a direction from a surface of the second doped semiconductor layer close to the second electrode to a surface of the second doped semiconductor layer close to the semiconductor substrate, and the vertical coordinate indicates a doping concentration of the second doped semiconductor layer. It can be learned by comparing FIG. 8-9 with FIG. 8-10 that, the first difference between the doping concentration of the side of the N-type doped semiconductor layer away from the semiconductor substrate and the doping concentration of the side close to the semiconductor substrate is larger.

By using the foregoing technical solution, because the first difference is large, it is beneficial to improving a transmission speed of electrons in the first doped semiconductor layer, that is, it is beneficial to fast transmission of the electrons from the first doped semiconductor layer to the first electrode. In this way, the quantity of the first openings can be suitably reduced, and reducing the quantity of the first openings is beneficial to reducing damage to the first doped semiconductor layer. In addition, the first difference is large, in other words, the doping concentration on the side of the first doped semiconductor layer located at the first opening away from the semiconductor substrate increases to a larger extent compared with the doping concentration on the side close to the semiconductor substrate. In this way, the contact resistance between the first electrode and the first doped semiconductor layer can be reduced, and a thickness of the first doped semiconductor layer can be reduced. This can reduce costs, and can also improve manufacturing efficiency of the solar cell.

It may be understood that in different embodiments, for example, under different laser conditions, the second difference may alternatively be greater than the first difference.

For example, a plurality of discontinuous protrusion parts 21 are formed on a side of a part of the first doped semiconductor layer exposed at the first opening 14-1 and facing away from the semiconductor substrate; and/or a plurality of discontinuous protrusion parts 21 are formed on a side of a part of the second doped semiconductor layer exposed at the second opening 14-2 and facing away from the semiconductor substrate. Features and effects of the discontinuous protrusion part in this embodiment are the same as the descriptions in the foregoing embodiment, and details are not described herein again.

For example, a quantity of discontinuous protrusion parts per unit area located in an edge region of the second opening 14-2 is greater than a quantity of discontinuous protrusion parts per unit area located in an edge region of the first opening 14-1.

In the foregoing technical solution, usually, because the P-type doped semiconductor layer corresponding to the second opening 14-2 has a low doping concentration, and the P-type doped semiconductor layer has an attribute that there are many holes and few electrons, it is not beneficial to forming a second electrode on the P-type doped semiconductor layer. It may be understood that, when electrodes of a same thickness are formed, difficulty in manufacturing a second electrode on the P-type doped semiconductor layer is greater than difficulty in manufacturing a first electrode on an N-type doped semiconductor layer corresponding to the first opening 14-1. In addition, for an opening, difficulty in manufacturing an electrode in an edge region of the opening is greater than difficulty in manufacturing an electrode in a middle region of the opening. Based on this, in some embodiments of the present disclosure, the quantity of discontinuous protrusion parts of the P-type doped semiconductor layer located per unit area of the edge region of the second opening 14-2 is greater than the quantity of discontinuous protrusion parts of the N-type doped semiconductor layer located per unit area of the edge region of the first opening 14-1. In this way, a manufacturing effect of the electrode in the edge region of the second opening 14-2 can be improved, and quality of the electrode formed in the edge region of the second opening is ensured, so that quality of electrodes formed in the edge region and in the middle region of the second opening 14-2 tends to be consistent, which helps improve carrier transmission effect in the second electrode.

It may be understood that in different embodiments, for example, under different laser conditions, a quantity of discontinuous protrusion parts per unit area located in an edge region of the first opening 14-1 is greater than a quantity of discontinuous protrusion parts per unit area located in an edge region of the second opening 14-2.

For example, a quantity of discontinuous protrusion parts per unit area located in a middle region of the first opening 14-1 is greater than a quantity of discontinuous protrusion parts per unit area located in a middle region of the second opening 14-2.

In the foregoing technical solution, usually, because the N-type doped semiconductor layer corresponding to the first opening 14-1 has a high doping concentration, and the N-type doped semiconductor layer has an attribute that there are many electrons and few holes, it is beneficial to forming an electrode on the N-type doped semiconductor layer. It may be understood that, when electrodes of a same thickness are formed, the difficulty in manufacturing an electrode on the N-type doped semiconductor layer is less than the difficulty in manufacturing an electrode on the P-type doped semiconductor layer corresponding to the second opening 14-2. In addition, for an opening, because the difficulty in manufacturing an electrode in the middle region of the opening is less than the difficulty in manufacturing an electrode in the edge region of the opening, in other words, it is less difficult to manufacture the electrode in the middle region of the N-type doped semiconductor layer, so that a speed of manufacturing the electrode in the middle region of the N-type doped semiconductor layer is higher, but an excessively high electrode manufacturing speed does not help improve the adhesion. Therefore, in some embodiments of the present disclosure, it is set that the quantity of discontinuous protrusion parts of the N-type doped semiconductor layer located per unit area of the middle region of the first opening is greater than the quantity of discontinuous protrusion parts located per unit area of the middle region of the second opening, so that a specific surface area of the middle region of the N-type doped semiconductor layer can be increased, thereby helping improve the binding force between the electrode in the middle region and the N-type doped semiconductor layer.

It may be understood that in different embodiments, for example, under different laser conditions, a quantity of discontinuous protrusion parts per unit area located in a middle region of the second opening 14-2 is greater than a quantity of discontinuous protrusion parts per unit area located in a middle region of the first opening 14-1.

For ease of description, the doped semiconductor layer in the following embodiment of the present disclosure may include one doped semiconductor layer, or may include at least one of the first doped semiconductor layer 12-1 and the second doped semiconductor layer 12-2. The opening in the following embodiment of the present disclosure may include one opening, or may include at least one of the first opening 14-1 and the second opening 14-2. The hole in the following embodiment of the present disclosure may include one hole, or may include at least one of a first hole 15-1 and a second hole 15-2. The annular protrusion part in the following embodiment of the present disclosure may include one annular protrusion part, or may include at least one of an annular protrusion part 16-1 of the first hole and an annular protrusion part 16-2 of the second hole.

For example, referring to FIG. 1 and FIG. 2, a groove 18 is formed on the side of the part of the doped semiconductor layer exposed at the opening and facing away from the semiconductor substrate, and the plurality of holes are formed on a surface on a side of the groove 18 facing away from the semiconductor substrate.

It may be understood that, a larger depth of the groove 18 indicates a smaller thickness of the part of the doped semiconductor layer exposed at the opening. However, when the solar cell is in a working state, the doped semiconductor layer can effectively separate and collect photo-generated carriers with opposite conductivity types. The thickness of the doped semiconductor layer affects a separating effect of the doped semiconductor layer on the photo-generated carriers. Based on this, a depth of the groove 18 and a minimum thickness of the part of the doped semiconductor layer located under the groove 18 may be determined according to a requirement for a carrier separating capability of the part of the doped semiconductor layer located under the groove 18 in an actual application scenario.

As shown in FIG. 3, the doped semiconductor layer has a first thickness d1 at the opening, the doped semiconductor layer has a second thickness d2 at a position other than the opening, and the first thickness d1 is less than the second thickness d2. The thickness of the doped semiconductor layer at the opening is less than the thickness at the position other than the opening, so that a transmission distance of carriers from the semiconductor substrate to the electrode is reduced, and a vertical transmission resistance is reduced. Especially for a non-sintered electrode, a thickness of the doped semiconductor layer can be made to be smaller, thereby reducing the vertical transmission resistance, ensuring that the doped semiconductor layer has a high carrier separating capability, reducing a carrier recombination rate, and further improving the photoelectric conversion efficiency of the solar cell.

Specific topography of the groove 18 may be determined according to an actual manufacturing process. For example, a side surface of the groove 18 may be a plane perpendicular to the surface of the semiconductor substrate; or may be a plane obliquely disposed relative to the surface of the semiconductor substrate; or the side surface of the groove 18 may be an arc surface recessed on two sides. In this way, with other factors being the same, compared with a case in which the side surface of the groove 18 is a plane, when the side surface of the groove 18 is an arc surface recessed on the two sides, the side surface of the groove 18 has a larger surface area, which can further enlarge the contact area between the electrode and the doped semiconductor layer, further reduce the risk that the electrode is separated from the doped semiconductor layer, and improve contact performance of the electrode.

For example, a longitudinal cross section of the groove 18 may be in a shape of a bowl. In this case, the side surface of the groove 18 is recessed on the two sides, so that the surface area of the side surface of the groove 18 can be increased, to further reduce the risk that the electrode is separated from the doped semiconductor layer, and improve the contact performance of the electrode. In addition, when the longitudinal cross section of the groove 18 in the shape of a bowl, topography of the groove 18 is regular, so as to prevent occurrence of problems such as a void in a process of filling the groove 18 with conductive materials used for manufacturing the electrode, thereby ensuring a high yield rate of the solar cell.

For example, the side of the doped semiconductor layer exposed at the opening has the first thickness, and a non-exposed part of the doped semiconductor layer not exposed at the opening includes a first non-exposed part at an edge of the opening of the dielectric layer and a remaining non-exposed part other than the first non-exposed part. The first non-exposed part has a third thickness, and the remaining non-exposed part has a fourth thickness, where the fourth thickness > the third thickness > the first thickness.

For example, along a thickness direction of the semiconductor substrate, a range of the first thickness of the doped semiconductor layer at the opening may be greater than or equal to 20 nm. For example, the first thickness of the doped semiconductor layer at the opening may be 20 nm, 40 nm, 60 nm, 80 nm, 100 nm, 150 nm, or the like. In this case, the minimum thickness of the part of the doped semiconductor layer below the opening is with the foregoing range, and this can prevent a thickness of a remaining part from being small when the side of the part of the doped semiconductor layer exposed at the opening is provided with the holes on the surface, ensure that the doped semiconductor layer has a high carrier separating capability, reduce a carrier recombination rate, and further improve the photoelectric conversion efficiency of the solar cell.

For example, a quantity of holes per unit area located in a middle region of the opening is greater than a quantity of holes per unit area located in an edge region of the opening. For example, as shown in FIG. 8-2, the quantity of the holes 15 per unit area in the middle region of the opening is larger than the quantity of the holes 15 per unit area in the edge region of the opening. In other words, the holes 15 in the middle region of the opening are denser than the holes 15 in the edge region.

For example, the middle region occupies 70% to 80% of an area of the opening. For example, the middle region occupies 70%, 71%, 72%, 72.5%, 73%, 74%, 75%, 75.5%, 76%, 77%, 78%, 79%, or 80% of the area of the opening.

It may be understood that, because when the metal material of the electrode is in contact with the doped semiconductor layer at the opening, a pulling force on the electrode is mainly concentrated in the middle region of the opening, and the quantity of holes in the middle region is greater than the quantity of holes in the edge region. The larger quantity of the holes in the middle region helps increase the contact area between the electrode and the doped semiconductor layer in the middle region. Therefore, a proportion of an area of the middle region to the area of the opening directly affects the structural stability of the electrode. In addition, the large quantity of holes in the middle region causes severe recombination in the middle region. Therefore, if the middle region is excessively large, severe recombination in the opening corresponding to the dielectric layer may be caused, reducing the photoelectric conversion efficiency; and if the middle region is excessively small, the middle region cannot effectively function to increase the binding force between the electrode and the doped semiconductor layer. Therefore, the range of the proportion of the middle region can effectively increase the contact area between the electrode and the doped semiconductor layer, thereby improving the binding force between the electrode and the doped semiconductor layer, and further improving the connection strength between the two, without causing excessive recombination.

For example, an average radial maximum dimension of holes in the middle region of the opening is greater than an average radial maximum dimension of holes in the edge region of the opening. For example, radial maximum dimensions of holes in a same area or radial maximum dimensions of holes of a same quantity may be measured separately in the middle region and the edge region, and an average value thereof is calculated, to obtain an average radial maximum dimension of holes in the middle region and the edge region. When the metal material of the electrode is in contact with the doped semiconductor layer at the opening, a pulling force on the metal material of the electrode is mainly concentrated in the middle region of the opening, and a larger average radial maximum dimension of the holes in the middle region facilitates disposition of more metal in the holes, thereby increasing the contact area between the electrode and the doped semiconductor layer, enhancing the binding force between the electrode and the doped semiconductor layer, further enhancing the connection strength between the two, reducing the risk that the electrode falls off from the doped semiconductor layer, and improving the structural reliability of the solar cell.

In the foregoing technical solution, when the metal material of the electrode is in contact with the doped semiconductor layer at the opening, a pulling force on the metal material of the electrode is mainly concentrated in the middle region of the opening. The quantity of holes per unit area in the middle region in the present disclosure is large, and this is beneficial to increasing a roughness of the middle region at the opening, and is further beneficial to increasing the contact area between the electrode and the doped semiconductor layer in the middle region of the opening, thereby enhancing the binding force between the electrode and the doped semiconductor layer, further enhancing the connection strength between the two, reducing the risk of the electrode falling off from the doped semiconductor layer, and improving the structural reliability of the solar cell.

For example, at least two holes 15 are in contact with each other. In this way, when the electrode is formed on the doped semiconductor layer, conductive materials used for manufacturing the electrode and formed in two or more holes in contact with each other are electrically connected together. In this way, the binding force between the electrode and the doped semiconductor layer can be increased, the connection strength between the two can be enhanced, the risk that the electrode is separated from the doped semiconductor layer can be reduced, and the structural reliability of the solar cell can be improved.

For example, the doped semiconductor layer includes a doped polycrystalline silicon layer, and the doped semiconductor layer further includes amorphous silicon disposed on a side of a part of the doped polycrystalline silicon layer exposed at the opening and facing away from the semiconductor substrate.

By using the foregoing technical solution, when the opening is disposed on the dielectric layer, a corrosion solution needs to be used to remove the residual by means of corrosion. Because the amorphous silicon has good corrosion resistance, the amorphous silicon is distributed in on the side of the part of the doped semiconductor layer exposed at the opening and facing away from the semiconductor substrate. In this way, the amorphous silicon can protect the underlying doped polycrystalline silicon layer, and prevent severe corrosion damage caused by the corrosion solution to the doped polycrystalline silicon layer under the amorphous silicon, causing severe recombination. In addition, the amorphous silicon has a good passivation effect, facilitating reducing recombination caused by direct contact between the doped polycrystalline silicon layer and the electrode.

In some embodiments, when the doped semiconductor layer is a doped polycrystalline silicon layer, the side of the part of the doped semiconductor layer exposed at the opening and facing away from the semiconductor substrate may further include at least one of microcrystalline silicon and nanocrystalline silicon. Beneficial effects of the microcrystalline silicon and the nanocrystalline silicon are similar to the foregoing beneficial effects of the amorphous silicon. Refer to the foregoing descriptions, and details are not described again.

For example, the doped semiconductor layer includes a doped polycrystalline silicon layer, and the doped semiconductor layer further includes amorphous silicon located at an edge of the opening of the dielectric layer, located below the dielectric layer, and disposed on a side of the doped polycrystalline silicon layer facing away from the semiconductor substrate.

By using the foregoing technical solution, when the opening is disposed on the dielectric layer, a corrosion solution needs to be used to remove the residual by means of corrosion. When the residual is removed by means of corrosion by using the corrosion solution, side corrosion also occurs to a part at an edge of the opening of the dielectric layer and located under the dielectric layer. In this case, because of a good corrosion resistance of the amorphous silicon, the amorphous silicon is distributed at the edge of the opening of the dielectric layer, below the dielectric layer, and on the side of the doped polycrystalline silicon layer facing away from the semiconductor substrate. In this way, the amorphous silicon can protect the doped polycrystalline silicon layer under the amorphous silicon layer, to prevent severe corrosion damage caused by the corrosion solution to the underlying doped polycrystalline silicon layer and causing severe recombination. In addition, the amorphous silicon has a good passivation effect, facilitating reducing a recombination loss caused by direct contact between the doped polycrystalline silicon layer and the electrode.

For example, along a direction parallel to the semiconductor substrate from the edge of the opening of the dielectric layer, a length in which the amorphous silicon is distributed is greater than 0 µm and less than or equal to 6 µm. Herein, calculation of the length in which the amorphous silicon is distributed is a length from the edge of the opening of the dielectric layer to the farthest position at which the amorphous silicon is distributed along the direction parallel to the semiconductor substrate and away from the edge of the opening. Herein, the direction parallel to the semiconductor substrate is perpendicular to the thickness direction of the semiconductor substrate.

It can be learned based on the foregoing function of the amorphous silicon that, if a range of the length in which the amorphous silicon is distributed is excessively large, because a horizontal transmission resistance of the amorphous silicon is larger than that of polycrystalline silicon, horizontal transmission of carriers is disadvantageous, and the photoelectric conversion efficiency of the solar cell is reduced. In addition, if the range of the length in which the amorphous silicon is distributed is large, large amount of heat is required when the opening is formed on the dielectric layer. The large amount of heat may cause excessive damage to the doped semiconductor layer when the opening is formed on the dielectric layer, and consequently, a passivation effect of the doped semiconductor layer is poor. Therefore, in the present disclosure, along the direction parallel to the semiconductor substrate from the edge of the opening of the dielectric layer, the length in which the amorphous silicon is distributed is less than or equal to 6 µm.

Further, if the range of the length in which the amorphous silicon is distributed is excessively small, the effect of preventing corrosion cannot be effectively achieved and the passivation effect is not obvious when the side corrosion is severe. Therefore, in some examples, the length in which the amorphous silicon is distributed from the edge of the opening of the dielectric layer along the direction parallel to the semiconductor substrate is greater than or equal to 0.001 µm.

For example, the length in which the amorphous silicon is distributed may be 0.001 µm, 0.007 µm, 0.01 µm, 0.07 µm, 0.09 µm, 0.1 µm, 0.3 µm, 0.5 µm, 0.7 µm, 0.9 µm, 1 µm, 2 µm, 3 µm, 5 µm, or 6 µm.

For example, along a thickness direction of the semiconductor substrate, a range of a depth of the amorphous silicon is greater than 0 nm and less than or equal to 350 nm.

In some embodiments, a depth of the amorphous silicon at a location on the side of the part of the doped semiconductor layer exposed at the opening and facing away from the semiconductor substrate on which a protrusion part (for example, an annular protrusion part or a discontinuous protrusion part) is distributed is greater than a depth of the amorphous silicon at a location without a protrusion part. For example, a range of the depth of the amorphous silicon corresponding to the position at which the protrusion part is distributed on the side of the part of the doped semiconductor layer exposed at the opening and facing away from the semiconductor substrate is greater than 0 nm and less than or equal to 350 nm, and a range of the depth of the amorphous silicon corresponding to the position without the protrusion part is greater than 0 nm and less than or equal to 50 nm. In most cases, the protrusion part is formed by fusing and then solidifying materials of the doped semiconductor layer. When the doped semiconductor layer is a doped polycrystalline silicon layer, a material of the protrusion part is mainly amorphous silicon. Therefore, the depth of the amorphous silicon of the protrusion part is greater than the depth of the amorphous silicon of a non-protrusion part.

When the foregoing technical solution is used, it is considered that if the depth of the amorphous silicon is excessively large, a carrier transmission resistance is large, and further, the electrical performance of the solar cell is affected. Therefore, the depth of the amorphous silicon is less than or equal to 350 nm.

Further, it is considered that if the range of the depth of the amorphous silicon is excessively small, the amorphous silicon cannot protect the underlying doped semiconductor layer and prevent the underlying doped semiconductor layer from being damaged by the corrosion solution, and cannot effectively passivate the surface of the doped polycrystalline silicon. Therefore, in some examples, the depth of the amorphous silicon is greater than or equal to 0.001 nm.

For example, the depth of the amorphous silicon along the thickness direction of the semiconductor substrate may be 0.001 nm, 0.005 nm, 0.009 nm, 0.01 nm, 0.05 nm, 0.1 nm, 0.8 nm, 1 nm, 6 nm, 10 nm, 50 nm, 100 nm, 200 nm, or 350 nm.

For example, referring to FIG. 8-11, an aperture 22 is formed at an edge of the opening of the dielectric layer 13 and between the dielectric layer 13 and the doped semiconductor layer 12 below. Herein, a size and a distribution quantity of apertures 22 are not limited.

Usually, in a process of forming the dielectric layer, hydrogen element is formed in the dielectric layer. For example, when a material of the dielectric layer includes aluminum oxide, in a process of depositing the aluminum oxide, because water participates in the reaction, redundant hydrogen is generated. For another example, when depositing silicon nitride, there are residual N-H bonds, and at a high temperature, the N-H bonds may be broken and recombined to generate hydrogen gas. Because the dielectric layer includes the hydrogen element, in this way, in a process of opening a mold on the dielectric layer by using a laser, hydrogen may escape from the dielectric layer under thermal influence. The hydrogen escaping process may cause film burst in a part of a non-opening region in the dielectric layer, and cause damage to the dielectric layer and the doped semiconductor layer, thereby affecting the passivation effect of the solar cell.

The aperture 22 in this embodiment may provide space for hydrogen escape during a laser mold opening process, to help alleviate or avoid film burst of the dielectric layer in the non-opening region caused by the laser mold opening, facilitating precisely controlling a size of the opening region, reducing damage caused by the laser mold opening to the doped semiconductor layer in the non-opening region, and effectively ensuring the passivation effect of the solar cell.

For example, along the direction parallel to the semiconductor substrate from the edge of the opening of the dielectric layer, a length in which the aperture 22 is distributed is greater than 0 µm and less than or equal to 5 µm. For example, calculation of the length in which the aperture 22 is distributed is a length from the edge of the opening of the dielectric layer to the farthest position at which the aperture is distributed along the direction parallel to the semiconductor substrate and away from the edge of the opening. Herein, the direction parallel to the semiconductor substrate is perpendicular to the thickness direction of the semiconductor substrate. It is considered that if the length in which the aperture 22 is distributed is excessively large, for example, is 10 µm, 20 µm, 30 µm, or larger, the dielectric layer easily cracks and falls off, affecting the passivation effect of the solar cell, thereby increasing a recombination loss of the doped semiconductor layer. Therefore, the length in which the aperture is distributed from the edge of the opening of the dielectric layer and in the direction parallel to the semiconductor substrate is less than or equal to 5 µm.

Further, if the length in which the aperture 22 is distributed is excessively small, because hydrogen may escape in the laser mold opening process, sufficient space cannot be provided for hydrogen escaping, and the dielectric layer in the non-opening region may still have a risk of film burst. Therefore, in some examples, the length in which the aperture is distributed from the edge of the opening of the dielectric layer along the direction parallel to the semiconductor substrate is greater than or equal to 0.01 µm.

The foregoing length in which the aperture is distributed from the edge of the opening of the dielectric layer along the direction parallel to the semiconductor substrate may be, for example, 0.01 µm, 0.3 µm, 0.5 µm, 0.7 µm, 0.9 µm, 1 µm, 2 µm, 3 µm, or 5 µm.

The range of the length in which the aperture is distributed provided in the present disclosure can provide suitable space for hydrogen escaping from the dielectric layer in the laser mold opening process, can effectively alleviate or avoid film burst of the dielectric layer in the non-opening region caused by the laser mold opening, is beneficial to accurately controlling the size of the opening region, and reduces damage caused by the laser mold opening to the doped semiconductor layer in the non-opening region. In addition, this can prevent cracking and falling off of the dielectric layer caused by an excessively large length in which the aperture is distributed, and is beneficial to preventing the cracking and falling off of the dielectric layer from affecting the passivation effect of the solar cell. Therefore, the damage caused by the laser mold opening is reduced, and this is beneficial to ensuring the passivation effect of the solar cell.

For example, along the direction parallel to the semiconductor substrate layer from the edge of the opening of the dielectric layer 13, the length in which the amorphous silicon is distributed is greater than the length in which the aperture 22 is distributed. Because when the mold is opened on the dielectric layer, a corrosion solution needs to be used to remove the residual. In a process of removing the residual by using the corrosion solution, the corrosion solution is more likely to remain in the aperture and does not easily flow out. To prevent the corrosion solution from corroding of the doped polycrystalline silicon in the aperture and causing damage to the doped polycrystalline silicon, in some embodiments of the present disclosure, amorphous silicon is formed at the edge of the opening of the dielectric layer, below the dielectric layer, and on the side of the doped polycrystalline silicon layer facing away from the semiconductor substrate, and the length in which amorphous silicon is distributed is greater than the length in which the aperture is distributed.

For example, the aperture 22 includes at least one metal material in the electrode.

By using the foregoing solution in the present disclosure, the aperture 22 includes at least one metal material in the electrode, so that the contact area between the electrode and the doped semiconductor layer can be increased. In this way, the contact resistance between the electrode and the doped semiconductor layer can be reduced, the binding force between the electrode and the doped semiconductor layer can be increased, the risk that the electrode is separated from the doped semiconductor layer can be reduced, and the structural reliability of the solar cell can be improved.

For example, the metal material includes one or more of nickel, copper, silver, or tin.

By using the foregoing solution in this embodiment, these metal materials are filled into the aperture, so that the contact area between the electrode and the doped semiconductor layer can be increased, the contact resistance between the electrode and the doped semiconductor layer can be reduced, the binding force between the electrode and the doped semiconductor layer can be increased, the connection strength between the two can be enhanced, the risk that the electrode is separated from the doped semiconductor layer can be reduced, and the structural reliability of the solar cell can be improved. In addition, these metal materials can also block diffusion of deep level impurities or other metal to the doped semiconductor layer and the semiconductor substrate, thereby reducing recombination of the doped semiconductor layer and the semiconductor substrate, and reducing the recombination loss.

For example, a part of the dielectric layer close to the opening warps toward a direction away from the doped semiconductor layer. As shown in a position shown by an arrow in FIG. 8-13, because the part of the dielectric layer close to the opening warps toward the direction away from the doped semiconductor layer, space is formed between the dielectric layer and the underlying doped semiconductor layer in the part of the dielectric layer close to the opening, to further provide space for escaping hydrogen generated by the dielectric layer under the action of the laser in the laser mold opening process, thereby helping alleviate or avoid film burst, reducing damage caused by the laser mold opening, helping avoid cracking and falling off of the dielectric layer which affect the passivation effect of the solar cell, and helping ensure the passivation effect of the solar cell.

For example, a range of an angle at which the part of the dielectric layer close to the opening warps toward the direction away from the doped semiconductor layer is greater than 0° and less than or equal to 20°. The angle is, for example, an angle α as shown in FIG. 4. For example, the angle is an angle formed by a surface on the side of the part of the dielectric layer close to the opening and facing the doped semiconductor layer relative to the first surface of the semiconductor substrate. One side of the angle corresponds to the first surface of the semiconductor substrate and is parallel to a direction of the first surface of the semiconductor substrate, and the other side corresponds to the surface on the side of the part of the opening of the dielectric layer and facing the doped semiconductor layer. It is considered that if the angle at which the part of the dielectric layer close to the opening warps toward the direction away from the doped semiconductor layer is excessively large, for example, is 30°, 40°, or another larger angle, the dielectric layer easily cracks and falls off, affecting the passivation effect of the solar cell, and causing the recombination loss of the doped semiconductor layer. Therefore, in this embodiment of the present disclosure, the angle by which the part of the dielectric layer close to the opening warps toward the direction away from the doped semiconductor layer is less than or equal to 20°.

Further, it is considered that if the angle by which the part of the dielectric layer close to the opening warps toward the direction away from the doped semiconductor layer is excessively small, it is not beneficial to providing space for escaping hydrogen in the laser mold opening process, and consequently, the dielectric layer in the non-opening region of the laser mold opening has a risk of film burst, in some examples, the angle by which the part of the dielectric layer close to the opening warps toward the direction away from the doped semiconductor layer is greater than or equal to 0.001°.

The angle at which the part of the dielectric layer close to the opening warps toward the direction away from the doped semiconductor layer may be, for example, 0.001°, 0.005°, 0.01°, 0.05°, 0.09°, 1°, 6°, 9°, 10°, 12°, 15°, 18°, or 20°.

The range of the angle at which the part of the dielectric layer close to the opening warps toward the direction away from the doped semiconductor layer provided in this embodiment of the present disclosure can provide suitable space for hydrogen escaping from the dielectric layer in the laser mold opening process, can alleviate or avoid film burst of the dielectric layer in the non-opening region caused by the laser mold opening, reduce damage caused by the laser mold opening to the doped semiconductor layer in the non-opening region, and can further prevent cracking and falling off of the dielectric layer caused by an excessively large warping angle. Therefore, the angle range can ensure the passivation effect of the solar cell, reduce damage caused by laser mold opening, and prevent cracking of the dielectric layer from affecting the passivation effect of the solar cell.

For example, as shown in FIG. 8-12, a concavity 23 is formed in an edge region of the opening, and FIG. 8-12 is a schematic partial enlarged view at a location A shown in FIG. 8-3. A radial maximum dimension of the concavity 23 is far smaller than a radial maximum dimension of the hole, there is no annular protrusion part around the concavity 23 (as shown in the figure, there is no white bright circle around the concavity 23), and the concavity 23 is mainly distributed in the edge region of the opening. The concavity helps increase a surface roughness and a specific surface area of the edge region of the opening, thereby further increasing the contact area between the electrode and the doped semiconductor layer, increasing the binding force between the two, enhancing the connection strength between the two, reducing the risk that the electrode is separated from the doped semiconductor layer, and improving the structural reliability of the solar cell.

For example, when the doped semiconductor layer includes an N-type doped semiconductor layer, the concavity 23 is distributed in the edge region of the opening of the N-type doped semiconductor layer.

Usually, because the N-type doped semiconductor layer has a high doping concentration, and the N-type doped semiconductor layer has an attribute that there are many electrons and few holes, it is beneficial to forming an electrode on the N-type doped semiconductor layer. It may be understood that, when electrodes of a same thickness are formed, the difficulty in manufacturing an electrode on the N-type doped semiconductor layer is less than the difficulty in manufacturing an electrode on the P-type doped semiconductor layer. In other words, a speed of forming the electrode on the N-type doped semiconductor layer is high, and this may cause a binding force between the electrode and the N-type doped semiconductor layer to be reduced. In addition, for an opening, because the difficulty in manufacturing an electrode in the edge region of the opening is greater than the difficulty in manufacturing an electrode in the middle region of the opening. Therefore, in some embodiments of the present disclosure, because the concavity 23 is distributed in the edge region of the opening of the N-type doped semiconductor layer, the specific surface area of the edge region of the opening of the N-type doped semiconductor layer can be increased, and the difficulty in manufacturing an electrode in the edge region can be reduced, thereby ensuring quality of the electrode formed in the edge region of the opening. In addition, the contact area between the electrode and the N-type doped semiconductor layer located in the edge region of the opening can be increased, the binding force between the electrode and the N-type doped semiconductor layer located in the edge region of the opening can be improved, and the contact resistance between the electrode and the N-type doped semiconductor layer located in the edge region of the opening can be reduced.

For example, referring to FIG. 8-2, a crack 24 is formed at an edge of the dielectric layer 13 close to the opening. When the electrode is formed at a position on the dielectric layer corresponding to the opening, because the crack 24 is formed at the edge of the dielectric layer close to the opening, materials forming the electrode can also be filled into the crack 24, and pass through the crack 24 to be electrically connected to the doped semiconductor layer. In this way, the binding force between the electrode and the doped semiconductor layer can be further improved. In addition, when mold opening is performed on the dielectric layer, a crack formed at the edge of the opening of the dielectric layer facilitates hydrogen escaping, and reduces a risk of film burst. This facilitates precise control of a size of the opening on the dielectric layer, and avoids severe recombination caused by damage to the doped semiconductor layer under the non-opening region.

For example, as shown in FIG. 8-13, silicon oxide is formed on the side of the part of the doped semiconductor layer exposed at the opening and facing away from the semiconductor substrate. In an embodiment, a thickness of silicon oxide formed on the annular protrusion part is large, further, silicon oxide distributed in a peripheral region (which for the hole, is a side facing away from the hole) of the annular protrusion part is concentrated, and the silicon oxide in the peripheral region of the annular protrusion part is thicker than the silicon oxide in the hole 15. It may be understood that, when the opening is disposed on the dielectric layer, a corrosion solution needs to be used to remove the residual by means of corrosion. When the residual is removed by using the corrosion solution, because the silicon oxide is located above the doped semiconductor layer, the corrosion solution preferentially interacts with the silicon oxide, so that corrosion of the next layer, namely, the doped semiconductor layer, by the corrosion solution can be reduced, thereby reducing damage cause by mold opening. In addition, the silicon oxide has a good passivation effect, and the silicon oxide can passivate the surface of the doped semiconductor layer, thereby helping reduce a recombination loss caused by direct contact between the doped semiconductor layer and the electrode.

It should be noted that, in some examples, the silicon oxide formed on the side of the part of the doped semiconductor layer exposed at the opening and facing away from the semiconductor substrate needs to be removed. Because a plurality of holes are formed on the side of the part of the doped semiconductor layer exposed at the opening and facing away from the semiconductor substrate, the holes can increase the contact area between the electrode and the doped semiconductor layer, improve the binding force, and reduce the contact resistance. Therefore, in some other examples, the silicon oxide formed on the side of the part of the doped semiconductor layer exposed at the opening and facing away from the semiconductor substrate may alternatively not be removed.

For example, when the material of the dielectric layer includes aluminum oxide, the side of the part of the doped semiconductor layer exposed at the opening and facing away from the semiconductor substrate includes aluminum. Because aluminum is a metal element, when there is residual aluminum element on the side of the part of the doped semiconductor layer exposed at the opening and facing away from the semiconductor substrate, the contact resistance between the electrode and the doped semiconductor layer can be lowered, which is more beneficial to carrier separating and reducing the carrier recombination rate, thereby further improving the photoelectric conversion efficiency of the solar cell.

For example, the part of the doped semiconductor layer exposed at the opening has a through hole penetrating the doped semiconductor layer. Herein, a size of the through hole penetrating the doped semiconductor layer may be at a scale of nanometer.

In some examples, the through hole penetrating the doped semiconductor layer is formed in the hole. When the part of the doped semiconductor layer exposed at the opening includes a through hole penetrating the doped semiconductor layer, in some examples, when the electrode is formed, the material forming the electrode may be directly in contact with the semiconductor substrate through the through hole. In this way, a small quantity of carriers generated by the semiconductor substrate can be directly transmitted to the electrode, thereby reducing the resistance, helping improve the carrier separating capability, and further improving the photoelectric conversion rate of the solar cell.

In this embodiment, the electrode 17 may be of a single-layer structure, for example, as shown in FIG. 1, FIG. 2, FIG. 4, and FIG. 5; or may be a stacked multi-layer structure, for example, as shown in FIG. 9-1 and FIG. 9-2, the electrode includes two stacked layers that are respectively a conductive contact layer 17-2 and a connection electrode 17-1 that are stacked.

For the back contact solar cell in FIG. 4 to FIG. 7, the electrode includes a first electrode 17A and a second electrode 17B. The first electrode 17A and the second electrode 17B are disposed on a side of the dielectric layer 13 away from the semiconductor substrate 11. The first electrode 17A is electrically connected to the first doped semiconductor layer 12-1 through the first opening 14-1, and the second electrode 17B is electrically connected to the second doped semiconductor layer 12-2 through the second opening 14-2. The electrical connection in the present disclosure may also be referred to as electrical coupling or electrical contact. At least one of the first electrode 17A and the second electrode 17B includes a conductive contact layer 17-2 and a connection electrode 17-1 that are stacked.

For ease of description, the electrode in the following embodiment of the present disclosure may include one electrode, or may include at least one of the first electrode 17A and the second electrode 17B. A feature of the at least one of the first electrode 17A and the second electrode 17B is the same as a feature of the following electrode.

The conductive contact layer 17-2 is located on a side of the electrode close to the doped semiconductor layer 12, and the connection electrode 17-1 is electrically connected to the doped semiconductor layer 12 through the conductive contact layer 17-2.

When the electrode is of a single-layer structure, the electrode may be formed by using a manner such as screen printing, chemical plating, electroplating, depositing, and etching. When the electrode includes a stacked multi-layer structure, each film layer may be formed by using a manner such as electroplating, chemical plating, screen printing, depositing, and etching.

The material of the electrode may be a metal material such as Ag, Cu, Al, Ni, Au, Zn, Sn, or Pb; or may be a metal oxide, including various TCOs, such as ITO, AZO, and IWO; or may be a metal nitride such as TiN; or may be a metal carbide such as TiC; or may be a metal sulfide, or another conductive connection material such as grapheme, or may be various combinations of the foregoing materials. Materials of the conductive contact layer 17-2 and the connection electrode 17-1 may alternatively be any one of the foregoing electrode materials or a suitable combination thereof.

It should be noted that, if the electrode includes the conductive contact layer 17-2 and the connection electrode 17-1, a material of the conductive contact layer 17-2 may be the same as or may be different from a material of the connection electrode 17-1. A material and a thickness of the conductive contact layer 17-2 may be determined based on the conductivity type of the doped semiconductor layer and according to an actual application scenario, which is not specifically limited herein. In an embodiment, the conductive contact layer 17-2 is formed by using a manner of electroplating or chemical plating, the material thereof may be, for example, one or more of Ag, Ni, and Sn, the connection electrode 17-1 is formed by using a manner of screen printing, and the material thereof may be, for example, silver pastes, copper pastes, or silver-coated copper pastes.

It may be understood that, when the electrode includes a multi-layer structure, because the electrically conductive contact layer 17-2 at the bottom layer is formed on the surface of the bumpy doped semiconductor layer, it is beneficial to increasing a binding force between the electrically conductive contact layer 17-2 and the doped semiconductor layer, and reducing a risk that the electrically conductive contact layer 17-2 is separated from the doped semiconductor layer, that is, reducing the risk that the electrode is separated from the doped semiconductor layer, thereby improving the structural reliability of the solar cell. Herein, when the conductive contact layer 17-2 is formed on the surface of the bumpy doped semiconductor layer, a surface on a side of the conductive contact layer 17-2 facing away from the semiconductor substrate may be flat, or may be bumpy. When the surface on the side of the conductive contact layer 17-2 facing away from the semiconductor substrate also has the bumpy surface feature, and the connection electrode 17-1 is formed, this helps increase a contact area between the conductive contact layer 17-2 and the connection electrode 17-1, and improve a binding force between the conductive contact layer 17-2 and the connection electrode 17-1, that is, further increasing the binding force between the electrode and the doped semiconductor layer, and further reducing the risk that the electrode is separated from the doped semiconductor layer. When the electrode has a single-layer structure, the electrode is formed on the surface of the bumpy doped semiconductor layer, and this helps increase the binding force between the electrode and the doped semiconductor layer, reduce the risk that the electrode is separated from the doped semiconductor layer, and improve the structural reliability of the solar cell.

An embodiment of the present disclosure further provides a photovoltaic module. The photovoltaic module includes a plurality of solar cell strings, where the plurality of solar cell strings may be connected together in series and/or in parallel. Each solar cell string includes a plurality of solar cells and a plurality of interconnection members, and the interconnection members are configured to connect the plurality of solar cells in series. It may be understood that, the interconnection members are electrically connected to electrodes of the plurality of solar cells, to connect the plurality of solar cells in series. Herein, the solar cell includes the solar cell according to any one of the foregoing embodiments.

In addition, the foregoing interconnection member may be, for example, a soldering tape, a metal wire, or a conductive tape.

In a technology of forming an electrode by using a low-temperature metallization process, a precondition for successfully performing low-temperature metallization is to ensure that an electrode material is in good contact with a surface of a doped semiconductor layer. If the contact is poor, it is difficult to perform low-temperature metallization, or even the low-temperature metallization cannot be performed at all. By using an existing electrode manufacturing method, after an opening is disposed on a dielectric layer by using a process such as laser etching, before the electrode is formed, the surface of the doped semiconductor layer needs to be preprocessed, to improve contact performance between the electrode and the doped semiconductor layer. However, after the foregoing preprocessing, a surface of a part of the doped semiconductor layer exposed at the opening is planar, and consequently, a binding force between the electrode and the doped semiconductor layer is reduced, causing a high risk that the electrode is separated from the doped semiconductor layer, and reducing structural reliability of the solar cell.

To resolve the foregoing problem, the embodiments of the present disclosure provide a manufacturing method of a solar cell. A manufacturing process is described below according to cross-sectional views of operations shown in FIG. 10 to FIG. 14. Specifically, the manufacturing method of a solar cell includes the following steps:

First, a semiconductor substrate is provided, where the semiconductor substrate has a first surface and a second surface opposite to each other. For a conductivity type and a surface topography of the semiconductor substrate, refer to the foregoing descriptions. Details are not described herein.

In an actual application process, when the first surface of the semiconductor substrate included in the solar cell is a light-facing surface, and the first surface is suede, the semiconductor substrate may be first cleaned to remove impurities on the surface of the semiconductor substrate. Then, a single-sided texturizing processing is performed on the first surface of the semiconductor substrate by using a texturizing solution such as an alkaline solution, to improve light absorption by the semiconductor substrate.

Next, a doped semiconductor layer is formed on the first surface and/or the second surface. For a material, a conductivity type, a forming position, and a thickness of the doped semiconductor layer, refer to the foregoing descriptions. A specific forming process of the doped semiconductor layer may be determined based on the forming position of the doped semiconductor layer on the semiconductor substrate.

For example, when the manufactured solar cell is a bifacial contact solar cell, an intrinsic semiconductor layer may be formed on the first surface and/or the second surface by using a process such as chemical vapor deposition. Then, as shown in FIG. 10, the intrinsic semiconductor layer is doped by using a process such as diffusion or ion implantation, so that the intrinsic semiconductor layer becomes the doped semiconductor layer.

For example, when the manufactured solar cell is a back contact solar cell, an entire layer of doped semiconductor layer may be first formed on the first surface and/or the second surface by using depositing and doping processes. Next, at least a process such as laser etching is used to selectively remove a part of the doped semiconductor layer.

Next, as shown in FIG. 11, a dielectric layer 13 is formed on a side of the doped semiconductor layer 12 facing away from the semiconductor substrate 11. Specifically, the dielectric layer 13 may be formed by using processes such as chemical vapor deposition and physical vapor deposition. For a material and a thickness of the dielectric layer 13, refer to the foregoing descriptions.

Next, as shown in FIG. 11 and FIG. 12, a penetrating opening 14 is formed on the dielectric layer 13, so that at least a part of the doped semiconductor layer 12 is exposed at the opening 14.

A forming method of the opening is not specifically limited in this embodiment of the present disclosure. For example, the opening may be formed by using a laser etching process and/or a wet etching process. When the opening is formed by using the laser etching process and the wet etching process, the laser etching process may be used first to form the opening, and then the wet etching process is used for processing. Alternatively, the opening may be formed by using a process such as wet etching or dry etching under an action of a mask of a corresponding mask layer.

It should be noted that, the laser etching process has high etching precision. Therefore, when the laser etching process is used to form the opening disposed in the dielectric layer, forming precision of the opening can be improved, thereby improving forming precision of the electrode, and improving a yield rate of the manufactured solar cell. In addition, as shown in FIG. 11, a specific etching depth corresponding to forming of the opening 14 may be equal to the thickness of the dielectric layer 13. In this case, the dielectric layer 13 is exactly etched through, so that large damage caused to the part of the doped semiconductor layer 12 exposed at the opening 14 by the etching process can be reduced. Alternatively, as shown in FIG. 12, the etching depth may be slightly greater than the thickness of the dielectric layer 13. In this case, the part of the doped semiconductor layer 12 exposed at the opening 14 is also etched to a partial depth, to ensure that the dielectric layer 13 is etched through, thereby ensuring that the electrode can penetrate through the dielectric layer 13 to be electrically connected to the doped semiconductor layer 12. In addition, the etching precision does not need to be strictly controlled to require that the etching depth is equal to the thickness of the dielectric layer 13, thereby reducing an etching difficulty. When the specific etching depth corresponding to the forming of the opening 14 slightly greater than the thickness of the dielectric layer 13, silicon residuals easily remain on the surface of the part of the doped semiconductor layer 12 exposed at the opening 14.

Next, as shown in FIG. 13, a plurality of holes are formed on a side of a part of the doped semiconductor layer 12 exposed at the opening 14 and facing away from the semiconductor substrate 11. It may be understood that, the opening and the hole may be formed in a same process step, or may be formed in different process steps. For example, the opening is first formed, and then the hole is formed.

For example, a groove 18 is formed on a side of a part of the doped semiconductor layer 12 exposed at the opening 14 and facing away from the semiconductor substrate 11, and a plurality of holes are formed on the surface of the groove 18.

In some other embodiments, the hole may be directly formed on the side of the part of the doped semiconductor layer 12 exposed at the opening 14 and facing away from the semiconductor substrate 11, and the groove 18 is not included.

For example, by using the wet etching process, a groove may be formed on a side of a part of the doped semiconductor layer exposed at the opening and facing away from the semiconductor substrate, and several holes may be formed on the surface of the groove. Specifically, an etching solution may include ammonium bifluoride and/or ammonium fluoride, to remove, by using the etching solution, silicon residuals remaining on the semiconductor substrate after the opening is disposed, and optionally, oxides formed on the part of the doped semiconductor layer exposed at the opening after the etching, thereby ensuring good contact performance between the doped semiconductor layer and the electrode subsequently formed on the groove. In addition, a groove having a hole on the surface is formed under erosion action of the etching solution on the part of the doped semiconductor layer exposed at the opening. In addition, in an actual application process, the material of the dielectric layer usually includes silicon nitride. Compared with a hydrogen fluoride solution, an ammonium bifluoride solution and an ammonium fluoride solution have moderate acidity. Specifically, when the etching solution includes ammonium bifluoride and/or ammonium fluoride, the etching solution can dissolve the foregoing oxides and silicon residuals. The groove having the hole on the surface is formed on the doped semiconductor layer, and this does not significantly affect the dielectric layer whose material includes the silicon nitride. In this way, excessive corrosion of the dielectric layer by the etching solution during a process of forming the groove is prevented, a good passivation effect of the dielectric layer is ensured, and high forming precision of the opening and the electrode is ensured at the same time.

In an actual application process, a concentration of the foregoing etching solution and a specific process condition of wet etching may be determined based on a type of the etching solution, a size of the groove to be formed, and a size and a quantity of the holes disposed on the surface of the groove. This is not specifically limited herein.

For example, when the etching solution includes ammonium bifluoride and/or ammonium fluoride, in the etching solution, a concentration of fluoride ion may be greater than or equal to 2 g/L and less than or equal to 13 g/L. For example, the concentration of the fluoride ion in the etching solution may be 2 g/L, 5 g/L, 7 g/L, 10 g/L, or 12 g/L. In this case, during etching, removal of the oxides and the silicon residuals and formation of the groove are mainly implemented by using a manner in which fluoride ions and silicon ions in the oxides react or fluoride ions and silicon atomics react to form silicon tetrafluoride. Based on this, if the concentration of the fluoride ions is within the foregoing range, it can prevent an etching effect of the etching solution on the foregoing silicon residuals and oxides from being poor because the concentration of the fluoride ions is small, and can ensure good contact performance between the electrode and the doped semiconductor layer. In addition, this can also prevent a low speed of forming the groove and the hole through etching by using the etching solution, which helps improve manufacturing efficiency. In addition, this can also avoid a case in which etching ending time is difficult to control caused by a high speed of forming the groove and the hole due to a large concentration of the fluoride ions, and ensure that topography of the groove and the hole meets a working requirement. In addition, this can also prevent the etching solution from significantly affecting the dielectric layer in the process of forming the groove and the hole, and ensure that the dielectric layer has the good passivation effect and a high opening forming precision.

Specifically, when the etching solution includes ammonium bifluoride and/or ammonium fluoride, concentrations of the ammonium bifluoride and/or the ammonium fluoride in the etching solution may be determined based on the concentration of the fluoride ions in the etching solution. For example, when the etching solution includes ammonium bifluoride and does not include ammonium fluoride, a concentration of ammonium bifluoride in the etching solution may be greater than or equal to 5 g/L and less than or equal to 20 g/L.

For example, etching time corresponding to the wet etching process may be greater than or equal to 10s and less than or equal to 60s. For example, the etching time may be 10s, 20s, 30s, 40s, 50s, or 60s. In this case, within a specific range, the etching time corresponding to the wet etching process is direct proportional to forming sizes of the groove and the hole. Therefore, the etching time being within the foregoing range can avoid a case in which a surface roughness of the groove is low caused by a small forming depth of the groove and a small diameter of the hole due to short etching time, and it is ensured that a contact area between the electrode and a part of the groove corresponding to the doped semiconductor layer is large. In addition, this can also prevent a thickness of a part of the doped semiconductor layer remaining under the groove from being small caused by a large forming depth of the groove and a large diameter of the hole due to long etching time, ensure a good carrier separating capability of the doped semiconductor layer, and further ensure good operating performance of the solar cell.

For example, a process temperature corresponding to the wet etching process may be greater than or equal to 15°C and less than or equal to 30°C. For example, the process temperature may be 15°C, 18°C, 20°C, 22°C, 24°C, 26°C, 28°C, or 30°C. Beneficial effects of this case is similar to beneficial effects of the etching time corresponding to the wet etching process being greater than or equal to 10s and less than or equal to 60s, and details are not described herein again.

In addition, in an actual application process, the etching solution may include an additive, so that in the process of forming the groove, a rate of etching of the dielectric layer by the etching solution is reduced to extremely low, thereby further improving the passivation effect of the dielectric layer on the doped semiconductor layer, and further improving forming precision of the opening and the electrode. For example, the foregoing etching solution may include an additive.

A type of the foregoing additive and a concentration of the additive in the etching solution may be determined based on the type of the etching solution and an actual application scenario, provided that the etching solution can be prevented from etching the dielectric layer.

For example, the additive may include at least one of 3-ethylbutoxypropylamine, phenylalanine, sodium benzoate, and sodium acetate. For example, the additive may be only 3-ethylbutoxypropylamine, phenylalanine, sodium benzoate, and sodium acetate. For another example, the additive may include any two of 3-ethylbutoxypropylamine, phenylalanine, sodium benzoate, and sodium acetate. For still another example, the additive may include any three of 3-ethylbutoxypropylamine, phenylalanine, sodium benzoate, and sodium acetate. For yet another example, the additive may include 3-ethylbutoxypropylamine, phenylalanine, sodium benzoate, and sodium acetate. In this case, 3-ethylbutoxypropylamine, phenylalanine, sodium benzoate, and sodium acetate have good solvability and dispersibility in the etching solution, and easily form, on the surface of the dielectric layer, a spatial hindrance preventing contact between the ammonium bifluoride and/or the ammonium fluoride and the dielectric layer, so that the corrosion rate of the dielectric layer by the etching solution is very low in the process of forming the groove, thereby further improving the passivation effect of the dielectric layer on the doped semiconductor layer, and further improving the forming precision of the opening and the electrode.

For example, in the etching solution, a concentration of the additive may be greater than or equal to 0.5 ml/L and less than or equal to 5 ml/L. For example, the concentration of the additive may be 0.5 ml/L, 1 ml/L, 2 ml/L, 3 ml/L, 4 ml/L, or 5 ml/L. In this case, if the concentration of the additive in the etching solution is within the foregoing range, it can prevent the spatial hindrance formed by the additive on the surface of the dielectric layer from being weak because the concentration of the additive is small, and it is ensured that corrosion efficiency of the etching solution on the dielectric layer is low. In addition, this can also prevent a large concentration of the additive from causing corrosion effect by the etching solution on the silicon residuals and the oxides, and from affecting the formation of the groove and the hole, thereby ensuring high connection strength and contact performance between the electrode and the doped semiconductor layer.

Moreover, when the electrode is subsequently formed by using the electroplating process, the etching solution may include a surfactant, to reduce a surface tension of an electroplating preprocessing solution, and make the electroplating preprocessing solution have strong moisturizing performance on the small-sized hole formed on the surface of the groove, thereby facilitating filling the hole with the metal material used for manufacturing the electrode, and ensuring a large contact area between the electrode and the doped semiconductor layer. For example, the etching solution may include a surfactant.

A type of the foregoing surfactant and a concentration of the surfactant in the etching solution may be determined based on the type of the etching solution and an actual application scenario, provided that the surface tension of the electroplating preprocessing solution can be reduced.

For example, the surfactant may include at least one of perfluorotriethylamine, perfluorohexane sulfonamide, and perfluorohexylsulfonyl fluoride. For example, the surfactant may be perfluorotriethylamine, perfluorohexane sulfonamide, or perfluorohexylsulfonyl fluoride. For another example, the surfactant may include any two of perfluorotriethylamine, perfluorohexane sulfonamide, and perfluorohexylsulfonyl fluoride. For still another example, the surfactant may include perfluorotriethylamine, perfluorohexane sulfonamide, and perfluorohexylsulfonyl fluoride. In this case, the foregoing perfluorotriethylamine, perfluorohexane sulfonamide, and perfluorohexylsulfonyl fluoride all have good moisturizing performance, and can ensure strong moisturizing performance of the electroplating preprocessing solution on the hole on the surface of the groove.

For example, in the etching solution, a concentration of the surfactant may be greater than or equal to 0.01 ml/L and less than or equal to 0.2 ml/L. For example, the concentration of the surfactant may be 0.01 ml/L, 0.04 ml/L, 0.08 ml/L, 0.12 ml/L, 0.16 ml/L, or 0.2 ml/L. In this case, the concentration of the surfactant being within the foregoing range can prevent a case in which the electrode materials are not filled or are not completely filled in the hole during electroplating because the electroplating preprocessing solution has poor moisturizing performance on the hole on the surface of the groove due to a small concentration of the surfactant, thereby ensuring that there is no gap between the electrode and the doped semiconductor layer, and ensuring a large contact area between the electrode and the doped semiconductor layer. In addition, it can also avoid a case in which a part of surfactant cannot work at all because the part of the surfactant is not in contact with the water caused by a large concentration of the surfactant, thereby improving utilization of the surfactant, and reducing a loss amount of the surfactant.

Then, as shown in FIG. 14, an electrode 17 is formed at the opening, making the electrode 17 to be electrically connected to the doped semiconductor layer 12.

In an actual application process, the electrode may be formed at the opening by using a process such as plating or physical vapor deposition, making the electrode to be electrically connected to the doped semiconductor layer. For a material of the electrode, refer to the foregoing descriptions, and details are not described herein.

When the electrode further includes a conductive contact layer, the conductive contact layer may be formed on at least a part of the surface of the opening by using a process such as depositing, etching, electroplating, chemical plating, or screen printing. For a material and a thickness of the conductive contact layer, refer to the foregoing descriptions, and details are not described herein. Then, as shown in FIG. 9-1, the connection electrode 17-1 may be formed on the conductive contact layer 17-2 in the foregoing manner.

For beneficial effects of the manufacturing method of a solar cell in the embodiments of the present invention, refer to the analysis of the beneficial effects of various implementations of the solar cell in the foregoing descriptions, and details are not described herein again.

In the foregoing descriptions, technical details such as composition and etching of each layer are not described in detail. However, a person skilled in the art should understand that a layer, a region, and the like of a required shape may be formed through various technical means. In addition, to form the same structure, a person skilled in the art may further design a method that is not exactly the same as the method described above. In addition, although the embodiments are separately described above, this does not mean that the measures in the embodiments cannot be advantageously used in combination.

The embodiments of the present disclosure are described above. However, the embodiments are merely for illustrative purposes and are not intended to limit the scope of the present disclosure. The scope of the present disclosure is defined by the appended claims and equivalents thereof. A person skilled in the art may make various substitutes and modifications without departing from the scope of the present disclosure, and the substitutes and modifications shall fall within the scope of the present disclosure.

## Claims

1. A solar cell, comprising:
a semiconductor substrate (11), the semiconductor substrate (11) having a first surface and a second surface opposite to each other;
a doped semiconductor layer (12), disposed on the first surface of the semiconductor substrate (11);
a dielectric layer (13), disposed on a side of the doped semiconductor layer (12) facing away from the semiconductor substrate (11); the dielectric layer (13) comprising a plurality of openings (14), the opening (14) exposing a partial region of the doped semiconductor layer (12); and a plurality of holes (15) being formed on a side of a part of the doped semiconductor layer (12) exposed at the opening (14) and facing away from the semiconductor substrate (11); and
an electrode (17), disposed on a side of the dielectric layer (13) away from the semiconductor substrate (11), the electrode (17) being electrically connected to the doped semiconductor layer (12) through the opening (14) on the dielectric layer (13).

2. The solar cell according to claim 1, wherein an annular protrusion part (16) is formed at an edge of the hole (15).

3. The solar cell according to claim 2, wherein
a width of the annular protrusion part (16) is greater than 0 µm and less than or equal to 0.3 µm; and/or
a height of the annular protrusion part (16) is greater than 0 µm and less than or equal to 0.5 µm; and/or
a range of a ratio of a radial maximum dimension of the hole (15) to a width of the annular protrusion part (16) is less than or equal to 60.

4. The solar cell according to claim 1, wherein
the hole (15) is a semi-spherical hole; and/or
a radial maximum dimension of the hole (15) is at a scale of nanometer, or a radial maximum dimension of the hole (15) is greater than 0 µm and less than or equal to 3 µm.

5. The solar cell according to claim 1, wherein a groove (18) is formed on the side of the part of the doped semiconductor layer (12) exposed at the opening (14) and facing away from the semiconductor substrate (11), and the plurality of holes (15) are formed on a surface on a side of the groove (18) facing away from the semiconductor substrate (11).

6. The solar cell according to claim 1, wherein a quantity of holes (15) per unit area located in a middle region of the opening (14) is greater than a quantity of holes (15) per unit area located in an edge region of the opening (14).

7. The solar cell according to claim 6, wherein the middle region accounts for 70% to 80% of an area of the opening (14).

8. The solar cell according to claim 1, wherein a plurality of discontinuous protrusion parts (21) are further formed on the side of the part of the doped semiconductor layer (12) exposed at the opening (14) and facing away from the semiconductor substrate (11).

9. The solar cell according to claim 8, wherein the doped semiconductor layer (12) is a P-type doped semiconductor layer, and a quantity of discontinuous protrusion parts (21) per unit area located in an edge region of the opening (14) is greater than a quantity of discontinuous protrusion parts (21) per unit area located in a middle region of the opening (14); or
the doped semiconductor layer (12) is an N-type doped semiconductor layer, and a quantity of discontinuous protrusion parts (21) per unit area located in a middle region of the opening (14) is greater than a quantity of discontinuous protrusion parts (21) per unit area located in an edge region of the opening (14).

10. The solar cell according to claim 8 or 9, wherein a height of the discontinuous protrusion part (21) is greater than 0 µm and less than or equal to 0.5 µm.

11. The solar cell according to claim 1, wherein the side of the part of the doped semiconductor layer (12) exposed at the opening (14) and facing away from the semiconductor substrate (11) has a fifth surface roughness, a side of a part of the doped semiconductor layer (12) not exposed at the opening (14) and facing away from the semiconductor substrate (11) has a sixth surface roughness, and the fifth surface roughness is greater than the sixth surface roughness.

12. The solar cell according to claim 1, wherein the doped semiconductor layer (12) comprises a first doped semiconductor layer (12-1) and a second doped semiconductor layer (12-2), and the first doped semiconductor layer (12-1) and the second doped semiconductor layer (12-2) are alternately disposed on the first surface of the semiconductor substrate (11); and the first doped semiconductor layer (12-1) is an N-type doped semiconductor layer, and the second doped semiconductor layer (12-2) is a P-type doped semiconductor layer; and
the plurality of openings (14) comprise: a plurality of first openings (14-1) and a plurality of second openings (14-2); wherein the first opening (14-1) exposes a partial region of the first doped semiconductor layer (12-1), and the second opening (14-2) exposes a partial region of the second doped semiconductor layer (12-2); and a region of the first doped semiconductor layer (12-1) exposed at the first opening (14-1) has a first surface roughness, a region of the second doped semiconductor layer (12-2) exposed at the second opening (14-2) has a second surface roughness, and the first surface roughness is different from the second surface roughness.

13. The solar cell according to claim 12, wherein a region of the first doped semiconductor layer (12-1) covered by the dielectric layer (13) has a third surface roughness, and a region of the second doped semiconductor layer (12-2) covered by the dielectric layer (13) has a fourth surface roughness; and
the third surface roughness is less than the fourth surface roughness.

14. The solar cell according to claim 12, wherein a plurality of first holes (15-1) are formed in the region of the first doped semiconductor layer (12-1) exposed at the first opening (14-1), a plurality of second holes (15-2) are formed in the region of the second doped semiconductor layer (12-2) exposed at the second opening (14-2), an annular protrusion part (16) is formed at each of an edge of the first hole (15-1) and an edge of the second hole (15-2), and an average height of the annular protrusion part (16) of the first hole (15-1) is different from an average height of the annular protrusion part (16) of the second hole (15-2).

15. The solar cell according to claim 12, wherein a plurality of first holes (15-1) are formed in the region of the first doped semiconductor layer (12-1) exposed at the first opening (14-1), a plurality of second holes (15-2) are formed in the region of the second doped semiconductor layer (12-2) exposed at the second opening (14-2); and a quantity of second holes (15-2) per unit area located in a middle region of the second opening (14-2) is greater than a quantity of first holes (15-1) per unit area located in a middle region of the first opening (14-1).

16. The solar cell according to claim 12, wherein a plurality of first holes (15-1) are formed in the region of the first doped semiconductor layer (12-1) exposed at the first opening (14-1), a plurality of second holes (15-2) are formed in the region of the second doped semiconductor layer (12-2) exposed at the second opening (14-2); and an average radial maximum dimension of holes (15) located in a middle region of the second opening (14-2) is greater than an average radial maximum dimension of holes (15) located in a middle region of the first opening (14-1).

17. The solar cell according to claim 1, wherein a doping concentration of a side of the doped semiconductor layer (12) located at the opening (14) away from the semiconductor substrate (11) is greater than a doping concentration of a side close to the semiconductor substrate (11).

18. The solar cell according to claim 12, wherein a difference between a doping concentration of a side of the first doped semiconductor layer (12-1) located at the first opening (14-1) away from the semiconductor substrate (11) and a doping concentration of a side close to the semiconductor substrate (11) is a first difference;
a difference between a doping concentration of a side of the second doped semiconductor layer (12-2) located at the second opening (14-2) away from the semiconductor substrate (11) and a doping concentration of a side close to the semiconductor substrate (11) is a second difference; and
the first difference is greater than the second difference.

19. The solar cell according to claim 12, wherein a plurality of discontinuous protrusion parts (21) are formed on a side of a part of the first doped semiconductor layer (12-1) exposed at the first opening (14-1) and facing away from the semiconductor substrate (11); and a plurality of discontinuous protrusion parts (21) are formed on a side of a part of the second doped semiconductor layer (12-2) exposed at the second opening (14-2) and facing away from the semiconductor substrate (11); wherein
a quantity of discontinuous protrusion parts (21) per unit area located in an edge region of the first opening (14-1) is less than a quantity of discontinuous protrusion parts (21) per unit area located in an edge region of the second opening (14-2); and/or
a quantity of discontinuous protrusion parts (21) per unit area located in a middle region of the first opening (14-1) is greater than a quantity of discontinuous protrusion parts (21) per unit area located in a middle region of the second opening (14-2).

20. The solar cell according to claim 1, wherein the doped semiconductor layer (12) comprises a doped polycrystalline silicon layer, and the doped semiconductor layer (12) further comprises amorphous silicon disposed on a side of a part of the doped polycrystalline silicon layer exposed at the opening (14) and facing away from the semiconductor substrate (11).

21. The solar cell according to claim 1, wherein the doped semiconductor layer (12) comprises a doped polycrystalline silicon layer, and the doped semiconductor layer (12) further comprises amorphous silicon located at an edge of the opening (14) of the dielectric layer (13), located below the dielectric layer (13), and disposed on a side of the doped polycrystalline silicon layer facing away from the semiconductor substrate (11).

22. The solar cell according to claim 1, wherein an aperture (22) is formed at an edge of the opening (14) of the dielectric layer (13) and between the dielectric layer (13) and the doped semiconductor layer (12) below.

23. The solar cell according to claim 22, wherein the doped semiconductor layer (12) comprises a doped polycrystalline silicon layer, and the doped semiconductor layer (12) further comprises amorphous silicon located at an edge of the opening (14) of the dielectric layer (13), located below the dielectric layer (13), and disposed on a side of the doped polycrystalline silicon layer facing away from the semiconductor substrate (11); and
along a direction parallel to the semiconductor substrate (11) from the edge of the opening (14) of the dielectric layer (13), and below the dielectric layer (13), a length in which the amorphous silicon is distributed is greater than a length in which the aperture (22) is distributed.

24. The solar cell according to claim 22, wherein the aperture (22) comprises at least one metal material comprised in the electrode (17).

25. The solar cell according to claim 1 or 23, wherein a part of the dielectric layer (13) close to the opening (14) warps toward a direction away from the doped semiconductor layer (12).

26. The solar cell according to claim 1, wherein a concavity (23) is formed in an edge region of the opening (14).

27. The solar cell according to claim 26, wherein the doped semiconductor layer (12) is an N-type doped semiconductor layer, and the concavity (23) is distributed in the edge region of the opening (14) of the N-type doped semiconductor layer.

28. The solar cell according to claim 1, wherein a crack (24) is formed on the dielectric layer (13) close to an edge of the opening (14).

29. The solar cell according to claim 1, wherein silicon oxide is formed on the side of the part of the doped semiconductor layer (12) exposed at the opening (14) and facing away from the semiconductor substrate (11).

30. The solar cell according to claim 1, wherein the dielectric layer (13) comprises aluminum oxide, and the side of the part of the doped semiconductor layer (12) exposed at the opening (14) and facing away from the semiconductor substrate (11) comprises aluminum.

31. The solar cell according to claim 1, wherein the part of the doped semiconductor layer (12) exposed at the opening (14) has a through hole penetrating the doped semiconductor layer (12).

32. A photovoltaic module, comprising a plurality of solar cell strings, the solar cell string comprising a plurality of solar cells and a plurality of interconnection members, and the interconnection members being configured to connect the plurality of solar cells in series; wherein
the solar cell is the solar cell according to any one of claims 1 to 31.

33. A manufacturing method of a solar cell, comprising:
providing a semiconductor substrate (11), the semiconductor substrate (11) having a first surface and a second surface opposite to each other;
forming a doped semiconductor layer (12) on the first surface and/or the second surface;
forming a dielectric layer (13) on a side of the doped semiconductor layer (12) facing away from the semiconductor substrate (11);
forming a penetrating opening (14) on the dielectric layer (13), so that at least a part of the doped semiconductor layer (12) is exposed from the opening (14), and forming a plurality of holes (15) on a side of a part of the doped semiconductor layer (12) exposed at the opening (14) and facing away from the semiconductor substrate (11); and
forming an electrode (17) at the opening (14), and making the electrode (17) to be electrically connected to the doped semiconductor layer (12).

34. The manufacturing method of a solar cell according to claim 33, wherein the opening (14) is formed by using a laser etching process.

35. The manufacturing method of a solar cell according to claim 33 or the 34, wherein a plurality of holes (15) are formed by using the laser etching process and/or a wet etching process on the side of the part of the doped semiconductor layer (12) exposed at the opening (14) and facing away from the semiconductor substrate (11), wherein an etching solution of the wet etching process comprises ammonium bifluoride and/or ammonium fluoride.

36. The manufacturing method of a solar cell according to claim 35, wherein the etching solution comprises an additive; and the additive comprises at least one of 3-ethylbutoxypropylamine, phenylalanine, sodium benzoate, and sodium acetate; and/or
the etching solution comprises a surfactant; and the surfactant comprises at least one of perfluorotriethylamine, perfluorohexane sulfonamide, and perfluorohexylsulfonyl fluoride; and/or
in the etching solution, a concentration of fluoride ion is greater than or equal to 2 g/L and less than or equal to 13 g/L; and/or
etching time corresponding to the wet etching process is greater than or equal to 10s and less than or equal to 60s; and/or
a process temperature corresponding to the wet etching process is greater than or equal to 15°C and less than or equal to 30°C.
